# EUROPEAN PATENT APPLICATION

(11) **EP 4 654 257 A1**
(43) Date of publication of application: **26.11.2025**
(21) Application number: 24744707.1
(22) Date of filing: 18.01.2024
(51) Int. Cl.: H01L 23/12, H05K 1/02, H05K 3/00, H05K 3/46

(54) **WIRING BOARD GROUP AND METHOD FOR MANUFACTURING SAME, AND WIRING BOARD AND METHOD FOR MANUFACTURING SAME**

(30) Priority: 18.01.2023 JP 2023006077; 16.02.2023 JP 2023022912
(71) Applicant: Dai Nippon Printing Co., Ltd., Tokyo 162-8001 (JP)
(72) Inventor: KURAMOCHI, Satoru, Tokyo 162-8001 (JP); KUDO, Hiroshi, Tokyo 162-8001 (JP); TAKANO, Takamasa, Tokyo 162-8001 (JP); TOGASHI, Kazuyoshi, Tokyo 162-8001 (JP); YOSHIMI, Seiichi, Tokyo 162-8001 (JP); MAWATARI, Hiroshi, Tokyo 162-8001 (JP); ARITSUKA, Yuki, Tokyo 162-8001 (JP)
(74) Representative: Müller-Boré & Partner Patentanwälte PartG mbB
(86) International application number: PCT/JP2024/001315
(87) International publication number: WO 2024/154787

(57) **Abstract**

A wiring-substrate group includes a carrier substrate; a release layer including a first lower surface and a first upper surface, the first lower surface facing the carrier substrate, the first upper surface being located opposite the first lower surface, the release layer containing resin; an intermediate layer including a second lower surface and a second upper surface, the second lower surface facing the first upper surface, the second upper surface being located opposite the second lower surface, the intermediate layer containing metal; and a plurality of redistribution layers each including a third lower surface and a third upper surface, the third lower surface facing the second upper surface at least partially, the third upper surface being located opposite the third lower surface, the plurality of redistribution layers being aligned in a first direction. The redistribution layers each include a first wiring layer constituting the third lower surface. The first wiring layer includes electrically conductive layers and an insulating layer, the electrically conductive layers each containing a metal that is different from the metal of the intermediate layer, the insulating layer containing resin. The intermediate layer has an opening at which the first upper surface is exposed.

## Description

### Technical Field

Embodiments of the present disclosure relate to a wiring-substrate group and a method of manufacturing the same, a wiring substrate and a method of manufacturing the same, and a method of manufacturing a redistribution layer.

### Background Art

Packaging techniques have been attracting attention in which a plurality of semiconductor devices having different functions, such as a CPU and a memory, are mounted at a high density on a single substrate. A structure that electrically connects such a plurality of semiconductor devices to each other is also called an interposer. The interposer encompasses, for example, a wiring layer that includes an electrically conductive layer and an insulating layer. The wiring layer plays a role of, for example, repositioning pads or terminals of the semiconductor devices to another location. Such a wiring layer is also called a redistribution layer.

The redistribution layer is provided on a substrate that is made of a rigid material such as glass. PTL 1 has disclosed a technique in which a redistribution layer released from a substrate is used as an interposer. Between the substrate and the redistribution layer is provided a release layer. In the step of releasing the redistribution layer from the substrate, for example, the release layer is irradiated with light. Subsequently, the redistribution layer is separated from the substrate.

### Citation List

### Patent Literature

PTL 1: Japanese Unexamined Patent Application Publication No. 2021-18997
PTL 2: Japanese Patent No. 6014907
PTL 3: Japanese Patent No. 6159820

### Summary of Invention

The step of forming the redistribution layer may include a step that is performed at a high temperature, such as a step of heating the insulating layer. In some cases such as a case where the release layer contains moisture, a low-molecular-weight component, and/or the like and a case where the molecular structure changes with time, gas may be generated inside the release layer during the step of forming the redistribution layer. If such gas accumulates at, for example, the interface between the release layer and the redistribution layer, the detachment of the redistribution layer may occur with an unintentional timing.

A first embodiment of the present disclosure is to provide a wiring-substrate group and a method of manufacturing the same and a wiring substrate and a method of manufacturing the same that can effectively solve the above problem.

The first embodiment of the present disclosure relates to [1] to [15] below.
[1] A wiring-substrate group comprising:
   a carrier substrate;
   a release layer including a first lower surface and a first upper surface, the first lower surface facing the carrier substrate, the first upper surface being located opposite the first lower surface, the release layer containing resin;
   an intermediate layer including a second lower surface and a second upper surface, the second lower surface facing the first upper surface, the second upper surface being located opposite the second lower surface, the intermediate layer containing metal; and
   a plurality of redistribution layers each including a third lower surface and a third upper surface, the third lower surface facing the second upper surface at least partially, the third upper surface being located opposite the third lower surface, the plurality of redistribution layers being aligned in a first direction,
   wherein the redistribution layers each include a first wiring layer constituting the third lower surface,
   wherein the first wiring layer includes electrically conductive layers and an insulating layer, the electrically conductive layers each containing a metal that is different from the metal of the intermediate layer, the insulating layer containing resin, and
   wherein the intermediate layer has an opening at which the first upper surface is exposed.
[2] In the wiring-substrate group according to [1], the opening may include a first opening located in plan view between the electrically conductive layers of each two of the redistribution layers, the two redistribution layers being adjacent to each other in the first direction.
[3] In the wiring-substrate group according to [1] or [2], the first opening may have a dimension in the first direction of 100 µm or more and 500 µm or less.
[4] In the wiring-substrate group according to any one of [1] to [3], a ratio of a dimension of the first opening in the first direction with respect to an arrangement pitch of the plurality of redistribution layers in the first direction may be 0.0010 or more and 0.10 or less.
[5] In the wiring-substrate group according to any one of [1] to [4], the insulating layer may include a second region and a first region, the second region being located in plan view in a region where the electrically conductive layers are distributed, the first region enclosing the second region in plan view, and the opening may include a plurality of second openings overlapping the second region in plan view.
[6] In the wiring-substrate group according to [5], the second openings may each have a dimension of 50 µm or less in plan view.
[7] In the wiring-substrate group according to [5] or [6], a ratio of an area of the plurality of second openings with respect to an area of the second region may be 0.0010 or more and 0.10 or less.
[8] In the wiring-substrate group according to any one of [5] to [7], the electrically conductive layers included in the first wiring layer may include a plurality of pads that are each located at the third lower surface and between corresponding two of the second openings, the two second openings being adjacent to each other in plan view.
[9] In the wiring-substrate group according to any one of [1] to [8], the intermediate layer may contain titanium, nickel, molybdenum, tungsten, tantalum, or chromium or an alloy containing any of such metals, and the electrically conductive layers may each contain copper or a copper alloy.
[10] In the wiring-substrate group according to any one of [1] to [9], a portion of the insulating layer included in the first wiring layer may be located at the opening and may be in contact with the first upper surface of the release layer.
[11] The wiring-substrate group according to any one of [1] to [10] may further comprise semiconductor devices located at the third upper surfaces of the redistribution layers.
[12] A method of manufacturing a wiring-substrate group, comprising:
   a step of preparing a multilayer body including a carrier substrate and a release layer, the release layer including a first lower surface and a first upper surface, the first lower surface facing the carrier substrate, the first upper surface being located opposite the first lower surface, the release layer containing resin;
   an intermediate-layer step of forming an intermediate layer including a second lower surface and a second upper surface, the second lower surface facing the first upper surface, the second upper surface being located opposite the second lower surface, the intermediate layer containing metal; and
   a redistribution-layer-forming step of forming a plurality of redistribution layers each including a third lower surface and a third upper surface, the third lower surface facing the second upper surface at least partially, the third upper surface being located opposite the third lower surface, the plurality of redistribution layers being aligned in a first direction,
   wherein the redistribution layers each include a first wiring layer constituting the third lower surface,
   wherein the first wiring layer includes electrically conductive layers and an insulating layer, the electrically conductive layers each containing a metal that is different from the metal of the intermediate layer, the insulating layer containing resin, and
   wherein the intermediate layer has an opening at which the first upper surface is exposed.
[13] In the method of manufacturing a wiring-substrate group according to [12], the redistribution-layer-forming step may include a step of applying a resin solution containing resin and a solvent to the intermediate layer, and a step of heating the resin solution applied to the intermediate layer.
[14] A wiring substrate comprising:
   a carrier substrate;
   a release layer including a first lower surface and a first upper surface, the first lower surface facing the carrier substrate, the first upper surface being located opposite the first lower surface, the release layer containing resin;
   an intermediate layer including a second lower surface and a second upper surface, the second lower surface facing the first upper surface, the second upper surface being located opposite the second lower surface, the intermediate layer containing metal; and
   a redistribution layer including a third lower surface and a third upper surface, the third lower surface facing the second upper surface at least partially, the third upper surface being located opposite the third lower surface,
   wherein the redistribution layer includes a first wiring layer constituting the third lower surface,
   wherein the first wiring layer includes electrically conductive layers and an insulating layer, the electrically conductive layers each containing a metal that is different from the metal of the intermediate layer, the insulating layer containing resin, and
   wherein the insulating layer includes a second region and a first region, the second region being located in plan view in a region where the electrically conductive layers are distributed, the first region enclosing the second region in plan view, and
   wherein the intermediate layer has a plurality of second openings that overlap the second region in plan view and at which the first upper surface is exposed.
[15] A method of manufacturing a wiring substrate, comprising:
   a step of preparing the wiring-substrate group according to any one of [1] to [11]; and
   a step of cutting the wiring-substrate group along a boundary between each two of the redistribution layers, the two redistribution layers being adjacent to each other in plan view.

According to the first embodiment of the present disclosure, the occurrence of detachment of the redistribution layer with an unintentional timing can be suppressed.

### Brief Description of Drawings

[Fig. 1] Fig. 1 is a plan view of a wiring-substrate group according to a first embodiment.
[Fig. 2] Fig. 2 is a sectional view of the wiring-substrate group, taken along line II-II given in Fig. 1.
[Fig. 3] Fig. 3 is a sectional view of redistribution layers in one example.
[Fig. 4] Fig. 4 is a sectional view of an electrically conductive layer in one example.
[Fig. 5A] Fig. 5A is a bottom view of an intermediate layer and third lower surfaces of the redistribution layers in one example.
[Fig. 5B] Fig. 5B is a bottom view of the intermediate layer and the third lower surfaces of the redistribution layers in the one example.
[Fig. 6] Fig. 6 illustrates in sectional view a step of forming a release layer.
[Fig. 7] Fig. 7 illustrates in sectional view a step of forming an intermediate layer and a seed layer.
[Fig. 8] Fig. 8 illustrates in sectional view a step of forming a first resist layer.
[Fig. 9] Fig. 9 illustrates in sectional view a step of forming a plating layer.
[Fig. 10] Fig. 10 illustrates in sectional view a step of partially removing the seed layer.
[Fig. 11] Fig. 11 illustrates in sectional view a step of forming a second resist layer.
[Fig. 12] Fig. 12 illustrates in sectional view a step of partially removing the intermediate layer.
[Fig. 13A] Fig. 13A is a sectional view of a first opening provided in the intermediate layer in one example.
[Fig. 13B] Fig. 13B is a plan view of the first opening provided in the intermediate layer in the one example.
[Fig. 14] Fig. 14 illustrates in sectional view a step of forming an insulating layer.
[Fig. 15] Fig. 15 illustrates in sectional view a step of dividing the wiring-substrate group.
[Fig. 16] Fig. 16 illustrates in sectional view a step of cutting portions of wiring substrates.
[Fig. 17] Fig. 17 illustrates in sectional view a step of joining the third upper surface of each redistribution layer to a first member.
[Fig. 18] Fig. 18 illustrates in sectional view a step of irradiating the release layer with light.
[Fig. 19] Fig. 19 illustrates in sectional view a step of separating the redistribution layer from a carrier substrate.
[Fig. 20] Fig. 20 illustrates in sectional view a step of removing the intermediate layer.
[Fig. 21] Fig. 21 illustrates in sectional view a step of joining the third lower surface of the redistribution layer to a second member.
[Fig. 22] Fig. 22 is a sectional view of the redistribution layer joined to the first member and to the second member in a first variation.
[Fig. 23] Fig. 23 illustrates a step of separating the first member from the redistribution layer in the first variation.
[Fig. 24] Fig. 24 illustrates in sectional view a step of making an opening in the intermediate layer in a second variation.
[Fig. 25] Fig. 25 illustrates in sectional view a step of forming a seed layer in the second variation.
[Fig. 26] Fig. 26 illustrates in sectional view a step of forming a plating layer in the second variation.
[Fig. 27] Fig. 27 is a sectional view of a wiring-substrate group in one example in a third variation.
[Fig. 28] Fig. 28 is a plan view of second openings provided in the intermediate layer in the one example in the third variation.
[Fig. 29] Fig. 29 is a plan view of the second openings provided in the intermediate layer in the one example in the third variation.
[Fig. 30] Fig. 30 is a plan view of a first opening and second openings provided in the intermediate layer in one example in a fourth variation.
[Fig. 31] Fig. 31 is a plan view of second openings provided in the intermediate layer in one example in a fifth variation.
[Fig. 32] Fig. 32 is a sectional view of a wiring-substrate group in one example in the fifth variation.
[Fig. 33] Fig. 33 illustrates in sectional view a step of forming a plating layer in a sixth variation.
[Fig. 34] Fig. 34 illustrates in sectional view a step of removing the first resist layer in the sixth variation.
[Fig. 35] Fig. 35 is a plan view of second openings provided in the intermediate layer in one example in the sixth variation.
[Fig. 36] Fig. 36 is a plan view of second openings provided in the intermediate layer in one example in the sixth variation.
[Fig. 37] Fig. 37 is a sectional view of second openings provided in the intermediate layer in one example in a seventh variation.
[Fig. 38] Fig. 38 illustrates exemplary products that include wiring substrate.
[Fig. 39] Fig. 39 is a schematic sectional view of a wiring-substrate group according to a second embodiment.
[Fig. 40] Fig. 40 is a plan view of the wiring-substrate group illustrated in Fig. 39.
[Fig. 41] Fig. 41 is a diagram illustrating a method of manufacturing redistribution layers from the wiring-substrate group illustrated in Fig. 39.
[Fig. 42] Fig. 42 is a diagram illustrating the method of manufacturing redistribution layers from the wiring-substrate group illustrated in Fig. 39.
[Fig. 43] Fig. 43 is a diagram illustrating the method of manufacturing redistribution layers from the wiring-substrate group illustrated in Fig. 39.
[Fig. 44] Fig. 44 is a diagram illustrating the method of manufacturing redistribution layers from the wiring-substrate group illustrated in Fig. 39.
[Fig. 45] Fig. 45 is a diagram illustrating the method of manufacturing redistribution layers from the wiring-substrate group illustrated in Fig. 39.
[Fig. 46] Fig. 46 is a diagram illustrating the method of manufacturing redistribution layers from the wiring-substrate group illustrated in Fig. 39.
[Fig. 47] Fig. 47 is a diagram illustrating the method of manufacturing redistribution layers from the wiring-substrate group illustrated in Fig. 39.
[Fig. 48] Fig. 48 is a diagram illustrating the method of manufacturing redistribution layers from the wiring-substrate group illustrated in Fig. 39.
[Fig. 49] Fig. 49 is a diagram illustrating the method of manufacturing redistribution layers from the wiring-substrate group illustrated in Fig. 39.
[Fig. 50] Fig. 50 is a diagram illustrating the method of manufacturing redistribution layers from the wiring-substrate group illustrated in Fig. 39.
[Fig. 51] Fig. 51 is a diagram illustrating the method of manufacturing redistribution layers from the wiring-substrate group illustrated in Fig. 39.
[Fig. 52] Fig. 52 is a diagram illustrating the method of manufacturing redistribution layers from the wiring-substrate group illustrated in Fig. 39.
[Fig. 53] Fig. 53 is a diagram illustrating the method of manufacturing redistribution layers from the wiring-substrate group illustrated in Fig. 39.
[Fig. 54] Fig. 54 is a diagram illustrating the method of manufacturing redistribution layers from the wiring-substrate group illustrated in Fig. 39.
[Fig. 55] Fig. 55 is a diagram illustrating the method of manufacturing redistribution layers from the wiring-substrate group illustrated in Fig. 39.
[Fig. 56] Fig. 56 is a diagram illustrating a redistribution layer according to a variation.

### Description of Embodiments

A configuration of a wiring-substrate group and a method of manufacturing the wiring-substrate group will now be described in detail with reference to the drawings. The following embodiments are only exemplary embodiments of the present disclosure, and the present disclosure is not to be construed as being limited thereto. The terms such as "substrate", "base material", "sheet", and "film" are not to be distinguished from one another solely on the basis of differences in name. For example, a "substrate" is a concept encompassing any member that can be called sheet or film. A "surface" refers to a surface of a plate-shaped member of interest that extends in a planar direction of the plate-shaped member of interest viewed as a whole and generally. The normal direction to be used regarding a plate-shaped member refers to a direction normal to a surface of the member. Terms such as "parallel" and "orthogonal", values representing length and angle, and other like expressions that are used in this specification to define shapes and geometrical conditions and the degrees of such factors are not bound by the exact meanings thereof and are to be construed as encompassing those that can be expected to exert the same or similar functions.

In this specification, when a plurality of possible upper limits and a plurality of possible lower limits are given regarding a parameter, the numerical range of that parameter may be defined as a combination of any one of the possible upper limits and any one of the possible lower limits. For example, let us consider a description "The parameter B is, for example, A1 or more and may be A2 or more or A3 or more. The parameter B is, for example, A4 or less and may be A5 or less or A6 or less." In this case, the numerical range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the drawings to be referred to in the following embodiments, elements that are the same as each other or have the same or similar functions to each other are denoted by the same or similar reference signs, and redundant description of such elements may be omitted. As a matter of convenience of description, the drawings may not be to scale, and some elements may be omitted from the drawings.

### (First Embodiment)

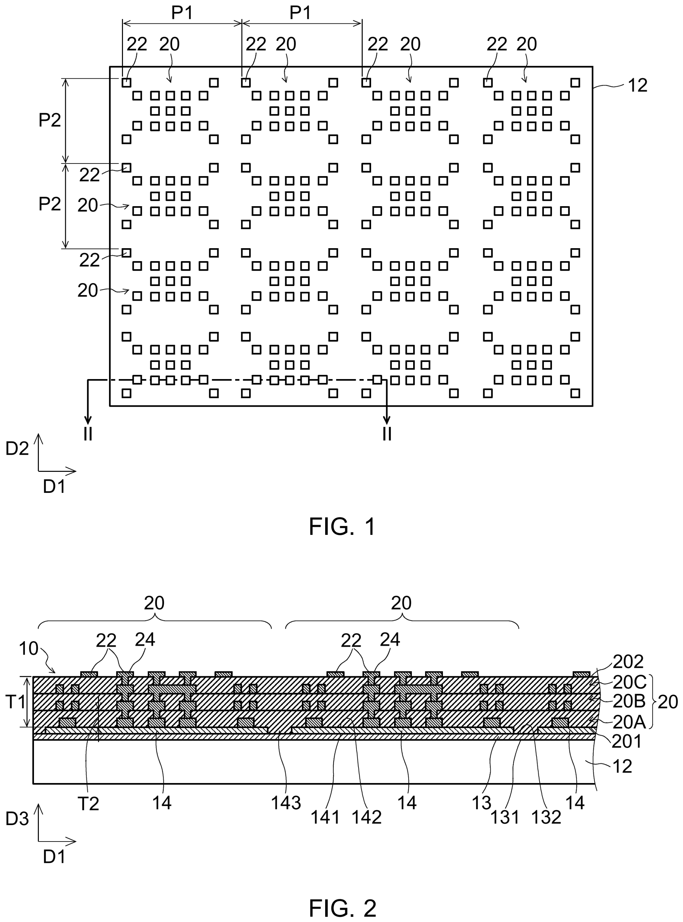

A first embodiment is based on and claims priority to Japanese Patent Application No. 2023-22912 filed on February 16, 2023. Fig. 1 is a plan view of a wiring-substrate group 10 in one example in the first embodiment. Fig. 2 is a sectional view of the wiring-substrate group 10 illustrated in Fig. 1, taken along line II-II. The wiring-substrate group 10 includes a plurality of wiring substrates that have the same configuration. As to be described below, dividing the wiring-substrate group 10 provides a plurality of wiring substrates.

The wiring-substrate group 10 has a first direction D1, a second direction D2, and a third direction D3. The first direction D1 and the second direction D2 are included in the planar direction of the wiring-substrate group 10. The first direction D1 is orthogonal to the second direction D2. The third direction D3 is the thickness direction of the wiring-substrate group 10. The third direction D3 is orthogonal to the first direction D1 and to the second direction D2.

The wiring-substrate group 10 includes a carrier substrate 12, a release layer 13, an intermediate layer 14, and a plurality of redistribution layers 20. The release layer 13 and the intermediate layer 14 are located between the carrier substrate 12 and the redistribution layers 20 in the thickness direction of the wiring-substrate group 10. The release layer 13 is located on the carrier substrate 12. The intermediate layer 14 is located between the release layer 13 and the redistribution layers 20.

Individual elements of the wiring-substrate group 10 will now be described.

### (Redistribution Layer)

The plurality of redistribution layers 20 have the same structure as one another. As illustrated in Fig. 1 for example, the plurality of redistribution layers 20 may have the same structure in plan view. As illustrated in Fig. 1, the plurality of redistribution layers 20 may be arranged regularly in the planar direction of the wiring-substrate group 10. For example, the plurality of redistribution layers 20 may be arranged regularly in the first direction D1 and in the second direction D2. The first direction D1 and the second direction D2 may each be parallel to corresponding ones of the sides of the carrier substrate 12.

In Fig. 1, reference sign P1 denotes the arrangement pitch of the redistribution layers 20 in the first direction D1, and reference sign P2 denotes the arrangement pitch of the redistribution layers 20 in the second direction D2.

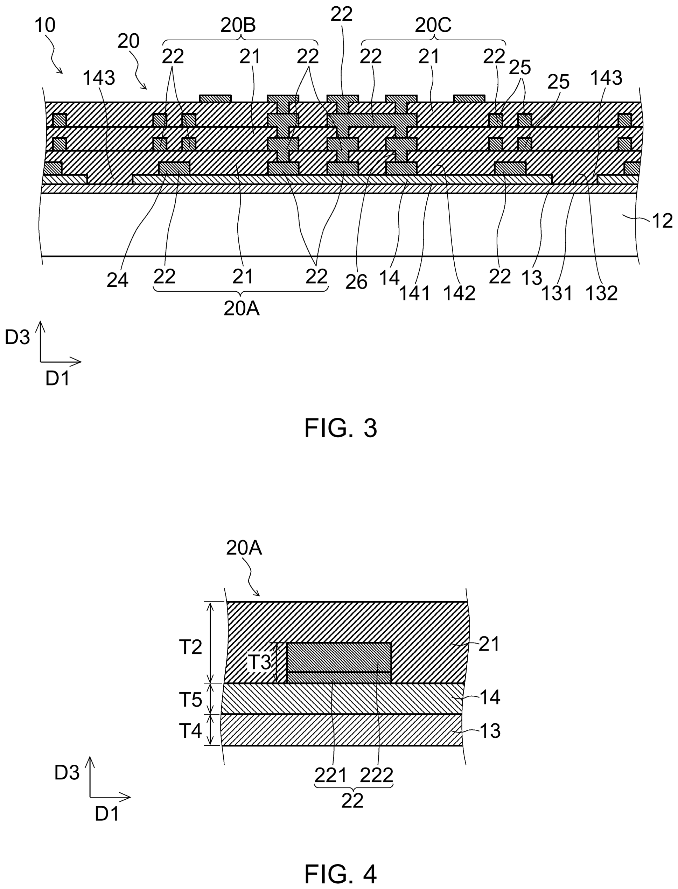

Figs. 2 and 3 are sectional views of the redistribution layers 20 in one example. Each redistribution layer 20 includes a third lower surface 201 and a third upper surface 202. The third lower surface 201 faces toward the carrier substrate 12. The third upper surface 202 is located opposite the third lower surface 201. The redistribution layer 20 includes an insulating layer 21 and a plurality of electrically conductive layers 22. The insulating layer 21 may spread from the third lower surface 201 to the third upper surface 202 in the third direction D3 of the wiring-substrate group 10.

In this specification, a "lower surface" such as the third lower surface 201 refers to a surface that faces toward the carrier substrate 12 in a state of being included in the wiring-substrate group 10. An "upper surface" refers to a surface located opposite the "lower surface" in the thickness direction.

The plurality of electrically conductive layers 22 may include one that serves as a pad 24. The pad 24 may include an upper surface or a lower surface that is not in contact with any insulating material such as the insulating layer 21. For example, if the pad 24 is located at the third lower surface 201 of the redistribution layer 20, the lower surface of the pad 24 is not in contact with any insulating material. For example, if the pad 24 is located at the third upper surface 202 of the redistribution layer 20, the upper surface of the pad 24 is not in contact with any insulating material.

The plurality of electrically conductive layers 22 may include one that serves as a wire 25. The wire 25 extends in the first direction D1 or the second direction D2. The upper surface and the lower surface of the wire 25 may each be in contact with an insulating material such as the insulating layer 21. The insulating material has an insulation characteristic. The insulating material may be either an organic material or an inorganic material.

The redistribution layer 20 may include a plurality of wiring layers that are stacked. In the example illustrated in Figs. 2 and 3, the redistribution layer 20 includes a first wiring layer 20A, a second wiring layer 20B, and a third wiring layer 20C. The plurality of wiring layers may each include an insulating layer 21 and a plurality of electrically conductive layers 22. The first wiring layer 20A may constitute the third lower surface 201 of the redistribution layer 20. The insulating layer 21 of the third wiring layer 20C may constitute the third upper surface 202 of the redistribution layer 20. The wiring-substrate group 10 may include an electrically conductive layer 22 that is located on the insulating layer 21 of the third wiring layer 20C and that constitutes a pad 24.

The plurality of electrically conductive layers 22 may include a one that serves as a through via 26. The through via 26 extends in the third direction D3. For example, the through via 26 is located in an opening provided in the insulating layer 21. The through via 26 can electrically connect, for example, the electrically conductive layers 22 of two wiring layers that are adjacent to each other in the third direction D3.

The redistribution layer 20 has a thickness T1. The thickness T1 is, for example, 30 µm or more and may be 35 µm or more. The thickness T1 is, for example, 50 µm or less and may be 45 µm or less. The thickness T1 is the distance in the third direction D3 from the third lower surface 201 to the third upper surface 202. Dimensions, such as the thickness T1, of the elements included in the wiring-substrate group 10 are calculated on the basis of a sectional image of the wiring-substrate group 10 that is taken through a scanning electron microscope.

The plurality of wiring layers included in the redistribution layer 20 each have a thickness T2, which is, for example, 4.0 µm or more and may be 6.0 µm or more. The thickness T2 of each of the plurality of wiring layers included in the redistribution layer 20 is, for example, 12.0 µm or less and may be 10.0 µm or less. The thickness T2 may be the same or vary among the plurality of wiring layers.

Fig. 4 is a sectional view of the electrically conductive layer 22 in one example. As illustrated in Fig. 4, the electrically conductive layer 22 may include a seed layer 221 and a plating layer 222. The seed layer 221 is a layer that has electrical conductivity and that is formed through physical deposition such as sputtering. The plating layer 222 is a layer that has electrical conductivity and that is formed on the seed layer 221 through an electroplating process.

The seed layer 221 may contain a metal material such as copper, nickel, titanium, chromium, or zinc. The seed layer 221 may contain a compound of any of the foregoing metals. The seed layer 221 may contain a plurality of layers. The plating layer 222 may contain a metal such as copper, gold, silver, platinum, rhodium, tin, aluminum, nickel, titanium, chromium, or zinc; or an alloy of any of the foregoing.

The electrically conductive layer 22 may contain a metal that is different from the metal constituting the intermediate layer 14. For example, the lower surface of the electrically conductive layer 22 may contain, as a chief component, a metal that is different from the metal constituting the intermediate layer 14. In the example illustrated in Fig. 4, the lower surface of the electrically conductive layer 22 is constituted by the seed layer 221. The "metal constituting the intermediate layer 14" refers to a metal as a chief component of the intermediate layer 14. The "chief component" refers to a metal or an alloy of the greatest rate of content.

For example, if the intermediate layer 14 contains as a chief component thereof titanium, nickel, molybdenum, tungsten, tantalum, or chromium or an alloy containing any of such metals, the electrically conductive layer 22 may contain as a chief component thereof copper or a copper alloy.

The electrically conductive layer 22 has a thickness T3, which is, for example, 0.1 µm or more and may be 0.5 µm or more or 1.0 µm or more. The thickness T3 of the electrically conductive layer 22 is, for example, 10.0 µm or less and may be 6.0 µm or less.

The insulating layer 21 contains an insulating material having an insulation characteristic. The insulating layer 21 may contain an organic material and/or an inorganic material. The insulating layer 21 may include a first insulating layer containing an organic material, and a second insulating layer containing an inorganic material. Examples of the organic material include polyimide and epoxy.

As illustrated in Fig. 2, the insulating layer 21 may spread over the plurality of redistribution layers 20. In other words, regarding a first redistribution layer 20 and a second redistribution layer 20 that are adjacent to each other in plan view, an insulating layer 21 for the first redistribution layer 20 and an insulating layer 21 for the second redistribution layer 20 may be continuous with each other.

### (Carrier Substrate)

The carrier substrate 12 is a member that supports the redistribution layers 20. The carrier substrate 12 may include, for example, a glass substrate, a quartz substrate, a sapphire substrate, a resin substrate, a silicon substrate, a silicon-carbide substrate, an alumina (Al2O3) substrate, an aluminum-nitride (AIN) substrate, a zirconium-oxide (ZrO2) substrate, a lithium-niobate substrate, a tantalum-niobate substrate, or the like. The resin substrate may contain an organic material. For example, the resin substrate may contain epoxy resin, polyethylene, polypropylene, or the like. The thickness of the carrier substrate 12 is, for example, 100 µm or more and may be 200 µm or more or 500 µm or more. The thickness of the carrier substrate 12 is, for example, 2 mm or less and may be 1.5 mm or less or 1 mm or less.

### (Release Layer)

The release layer 13 is a layer intended to facilitate the work of releasing the redistribution layer 20 from the carrier substrate 12. The release layer 13 includes a first lower surface 131, which faces the carrier substrate 12; and a first upper surface, which is located opposite the first lower surface 131. The release layer 13 contains, for example, resin.

The release layer 13 is composed such that the adhesiveness between the release layer 13 and the redistribution layer 20 is reduced by a certain trigger. The trigger may be the irradiation of the release layer 13 with light at a specific wavelength. For example, the release layer 13 may be decomposed through the irradiation of the release layer 13 with light at a specific wavelength. The trigger may alternatively be the heating of the release layer 13. For example, the release layer 13 may contain thermoplastic resin.

The release layer 13 has a thickness T4, which is, for example, 0.1 µm or more and may be 0.2 µm or more or 0.3 µm or more. The thickness T4 of the release layer 13 is, for example, 1.0 µm or less and may be 0.8 µm or less or 0.5 µm or less.

### (Intermediate Layer)

The intermediate layer 14 is a layer located between the release layer 13 and the redistribution layer 20. The intermediate layer 14 includes a second lower surface 141, which faces the first upper surface 132 of the release layer 13; and a second upper surface 142, which is located opposite the second lower surface 141. The second upper surface 142 faces the third lower surface 201 of the redistribution layer 20. The intermediate layer 14 spreads in such a manner as to overlap a plurality of electrically conductive layers 22 in plan view. For example, the intermediate layer 14 spreads in such a manner as to overlap a plurality of electrically conductive layers 22 included in a single first wiring layer 20A in plan view.

The intermediate layer 14 contains metal. As described above, the intermediate layer 14 may contain as a chief component thereof a metal that is different from the metal constituting the lower surface of the electrically conductive layer 22. Preferably, the intermediate layer 14 is composed such that the adhesiveness of the intermediate layer 14 with respect to the release layer 13 becomes higher than the adhesiveness of the lower surface of the electrically conductive layer 22 with respect to the release layer 13.

The intermediate layer 14 has a light-blocking characteristic that is given by the metal. Therefore, in a case where the release layer 13 is irradiated with light in a releasing step of releasing the redistribution layer 20 from the carrier substrate 12, the intermediate layer 14 suppresses the light reaching the redistribution layer 20. Thus, for example, a change in the state of the insulating layer 21 of the redistribution layer 20 because of the light irradiation can be suppressed. Hereinafter, such a function of the intermediate layer 14 is also referred to as a "first function of the intermediate layer 14".

The intermediate layer 14 may function to suppress the propagation of the change in the state of the release layer 13 during the releasing step to the redistribution layer 20. If the insulating layer 21 of the redistribution layer 20 is in contact with the release layer 13 over a wide area, the expansion, temperature rise, and/or the like that occurs in the release layer 13 during the releasing step tends to propagate to the insulating layer 21. Consequently, the characteristic of the redistribution layer 20 may be deteriorated, and/or the redistribution layer 20 may become difficult to release from the release layer 13. Since the intermediate layer 14 is provided between the release layer 13 and the redistribution layer 20, the occurrence of such problems can be suppressed. Hereinafter, such a function of the intermediate layer 14 is also referred to as a "second function of the intermediate layer 14".

The intermediate layer 14 may function to facilitate the work of releasing the redistribution layer 20 from the carrier substrate 12. In a case where the release layer 13 and the insulating layer 21 of the redistribution layer 20 contain the same resin, if the insulating layer 21 is in contact with the release layer 13, the releasing may be hindered. Since the intermediate layer 14 is provided between the release layer 13 and the redistribution layer 20, the occurrence of such a problem can be suppressed. Hereinafter, such a function of the intermediate layer 14 is also referred to as a "third function of the intermediate layer 14".

The intermediate layer 14 may function to suppress the occurrence of any damage to the release layer 13 that is attributed to a step of forming the redistribution layer 20. A step of forming the insulating layer 21 of the redistribution layer 20 includes, for example, a step of applying a solution containing resin and a solvent. If the solvent touches the release layer 13, the solvent may be absorbed by the release layer 13 to swell the release layer 13. Since the intermediate layer 14 is provided between the release layer 13 and the redistribution layer 20, the occurrence of such a problem can be suppressed. Hereinafter, such a function of the intermediate layer 14 is also referred to as a "fourth function of the intermediate layer 14".

In the present embodiment, the intermediate layer 14 may realize all of the first to fourth functions described above, or the intermediate layer 14 may realize one or more of the first to fourth functions.

The intermediate layer 14 has a thickness T5, which is, for example, 30 nm or more and may be 50 nm or more or 100 nm or more. The thickness T5 of the intermediate layer 14 is, for example, 2.0 µm or less and may be 1.0 µm or less or 500 nm or less.

According to researches made by the present inventors, it has been found that completely covering the first upper surface 132 of the release layer 13 with the intermediate layer 14 may bring another problem. The release layer 13 may contain a component with a low boiling point, such as moisture and/or a low-molecular-weight component. When the temperature of the release layer 13 rises because of the step of forming the redistribution layer, gas may be generated inside the release layer 13. Depending on the material, light or heat attributed to the storage environment may change the molecular structure and thus generates gas. If such gas accumulates at, for example, the interface between the release layer 13 and the intermediate layer 14, the intermediate layer 14 may be detached from the release layer 13 with an unintentional timing.

To solve such a problem, the present embodiment proposes the provision of an opening 143 in a portion of the intermediate layer 14 as illustrated in Figs. 2 and 3. The gas generated inside the release layer 13 is discharged through the opening 143. Therefore, the detachment of the intermediate layer 14 from the release layer 13 because of the gas can be suppressed.

Note that an increase in the area of the opening 143 may deteriorate any of the first to fourth functions of the intermediate layer 14 described above and/or the like. Therefore, it is preferable to limit the area of the opening 143.

The opening 143 of the intermediate layer 14 will now be described in detail. As illustrated in Figs. 2 and 3, the opening 143 extends through the intermediate layer 14 in the thickness direction. Therefore, a portion of the first upper surface 132 of the release layer 13 is exposed at the opening 143. The third lower surface 201 of the redistribution layer 20 includes a portion facing the second upper surface 142 of the intermediate layer 14, and a portion located at the opening 143 and facing the first upper surface 132 of the release layer 13. A portion of the insulating layer 21 of the redistribution layer 20 that is located at the opening 143 may be in contact with the first upper surface 132 of the release layer 13. The gas generated inside the release layer 13 is discharged to the outside of the wiring-substrate group 10 through the opening 143 and the insulating layer 21.

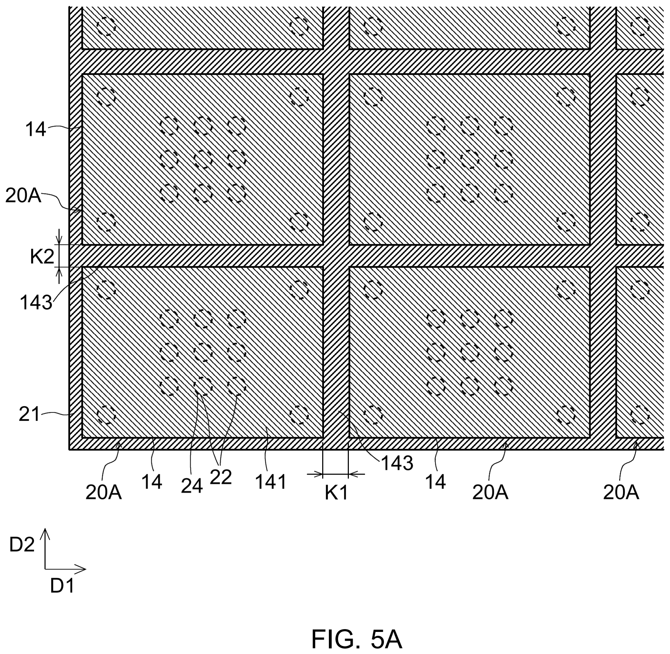

Fig. 5A is a bottom view of the intermediate layer 14 and the third lower surfaces 201 of redistribution layers 20 in one example. It can also be said that Fig. 5A is a rear view of the wiring-substrate group 10 with the carrier substrate 12 and the release layer 13 thereof removed.

As illustrated in Fig. 5A, the opening 143 may be located at the boundary between the first wiring layers 20A of each two of the redistribution layers 20 that are adjacent to each other in plan view. Hereinafter, an opening located at the boundary of each first wiring layer 20A is also referred to as a "first opening". The first opening 143 is located between the electrically conductive layers 22 of the first wiring layers 20A of each two of the redistribution layers 20 that are adjacent to each other in plan view.

The first opening 143 may extend along the boundary of each first wiring layer 20A. For example, the first opening 143 may include segments extending in the first direction D1, and segments extending in the second direction D2.

Reference sign K1 denotes a dimension in the first direction D1 of the first opening 143 located at each of the boundaries between those first wiring layers 20A that are aligned in the first direction D1. Reference sign K2 denotes a dimension in the second direction D2 of the first opening 143 located at each of the boundaries between those first wiring layers 20A that are aligned in the second direction D2. The dimensions K1 and K2 of the first opening 143 are each, for example, 100 µm or more and may be 200 µm or more. Thus, the gas generated inside the release layer 13 flows through the first opening 143 to be appropriately discharged. The dimensions K1 and K2 of the first opening 143 are each, for example, 500 µm or less and may be 400 µm or less. Thus, the deterioration of any of the first to fourth functions of the intermediate layer 14 described above and/or the like can be suppressed. Dimensions of openings, including the first opening 143, provided in the intermediate layer 14 are defined at the second lower surface 141.

The dimensions K1 and K2 of the first opening 143 may be defined relative to the arrangement pitches P1 and P2 of the redistribution layers 20. The ratio, K1/P1, of the dimension K1 to the arrangement pitch P1 is, for example, 0.0010 or more and may be 0.0030 or more or 0.010 or more. K1/P1 is, for example, 0.10 or less and may be 0.050 or less or 0.020 or less. The numerical range of K1/P1 can also be taken as the numerical range of the ratio, K2/P2, of the dimension K2 to the arrangement pitch P2.

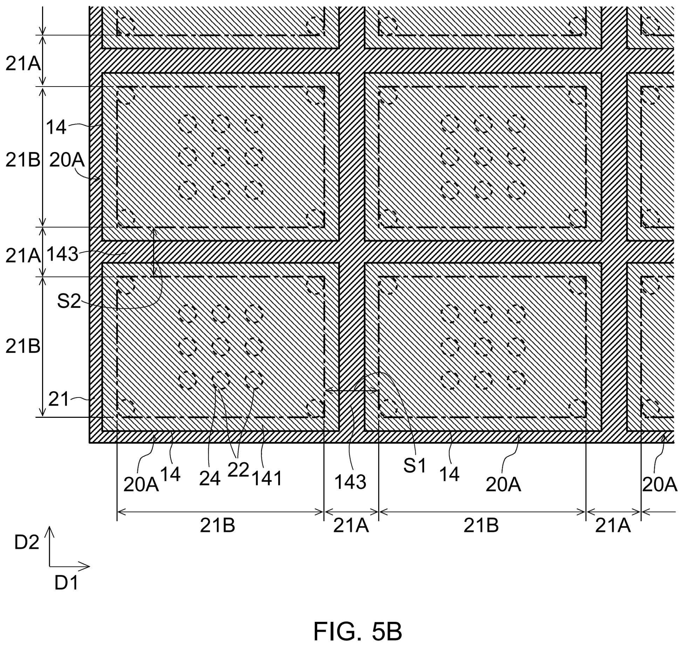

The dimensions of the first opening 143 may be defined relative to the dimension of a first region of each redistribution layer 20. The first region and a second region of the redistribution layer 20 will now be described with reference to Fig. 5B. Fig. 5B is a diagram obtained by adding to Fig. 5A one-dot chain lines each representing the boundary between a first region 21A and a second region 21B.

The insulating layer 21 of the first wiring layer 20A includes the first region 21A and the second region 21B. In other words, the insulating layer 21 of the first wiring layer 20A is sectioned into the first region 21A and the second region 21B. As illustrated in plan view in Fig. 5B, the second region 21B is located in a region of the first wiring layer 20A where the plurality of electrically conductive layers 22 are distributed. The first region 21A encloses the second region 21B in plan view. The boundary between the first region 21A and the second region 21B is defined by a virtual rectangle that encloses all of the electrically conductive layers 22 included in the first wiring layer 20A of a single redistribution layer 20. The region enclosed by the rectangle is the second region 21B. The rectangle includes a pair of sides extending in the first direction D1, and a pair of sides extending in the second direction D2. Each of the sides of the rectangle circumscribes corresponding ones of the electrically conductive layers 22. The first opening 143 of the intermediate layer 14 is located in the first region 21A in plan view.

In Fig. 5B, reference sign S1 denotes the dimension in the first direction D1 of the first region 21A located between each two of the second regions 21B that are adjacent to each other in the first direction D1. The dimension K1 of the first opening 143 may be defined relative to the dimension S1 of the first region 21A. The ratio, K1/S1, of the dimension K1 to the dimension S1 is, for example, 0.01 or more and may be 0.03 or more or 0.10 or more. K1/S1 is, for example, 0.50 or less and may be 0.30 or less or 0.20 or less.

In Fig. 5B, reference sign S2 denotes the dimension in the second direction D2 of the first region 21A located between each two of the second regions 21B that are adjacent to each other in the second direction D2. The numerical range of K1/S1 can also be taken as the numerical range of the ratio, K2/S2, of the dimension K2 to the dimension S2.

### (Method of Manufacturing Wiring-Substrate Group)

A method of manufacturing the wiring-substrate group 10 will now be described.

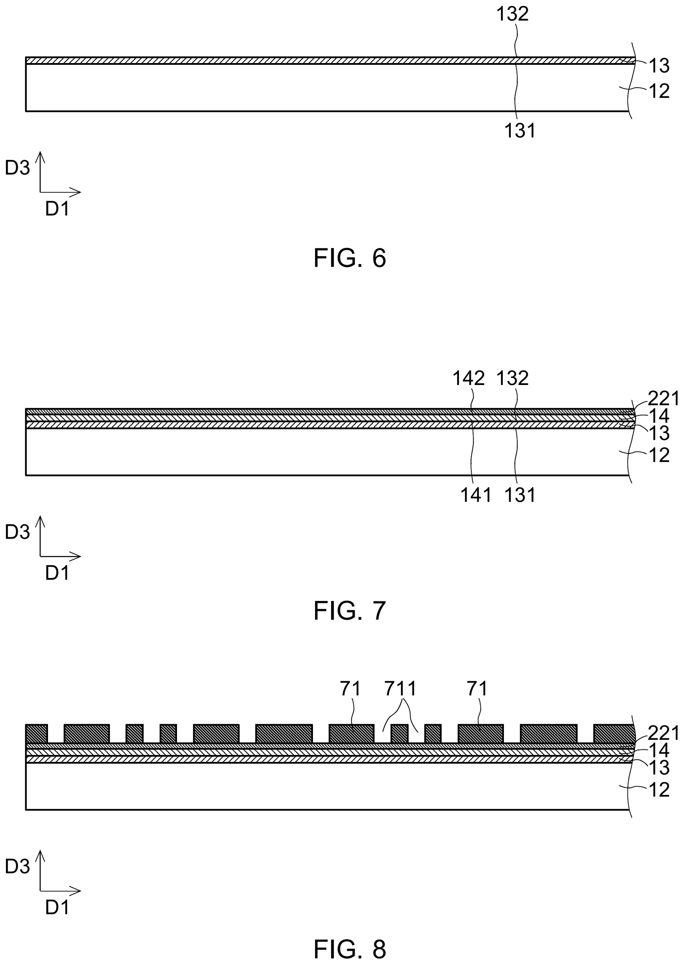

First, as illustrated in Fig. 6, a carrier substrate 12 is prepared. Subsequently, as illustrated in Fig. 6, a release layer 13 is formed on the carrier substrate 12. The step of forming the release layer 13 includes, for example, an application step of applying a solution containing resin and a solvent, and a drying step of evaporating the solvent after the application step. Examples of the solvent include propylene glycol monomethyl ether, 2-methoxy-1-methylethyl acetate, N-methyl-2-pyrrolidone, γ-butyrolactone, ethyl lactate, toluene, and the like. The drying step includes, for example, a step of heating the carrier substrate 12.

Subsequently, as illustrated in Fig. 7, an intermediate layer 14 is formed on the first upper surface 132 of the release layer 13. For example, the intermediate layer 14 is formed through a sputtering step. Subsequently, as illustrated in Fig. 7, a seed layer 221 is formed on the second upper surface 142 of the intermediate layer 14. For example, the seed layer 221 is formed through a sputtering step.

Subsequently, as illustrated in Fig. 8, a first resist layer 71 is formed on the seed layer 221. The first resist layer 71 has openings 711, which each extend through the first resist layer 71 in the thickness direction. The openings 711 are in a pattern corresponding to that of the plating layer 222 in plan view.

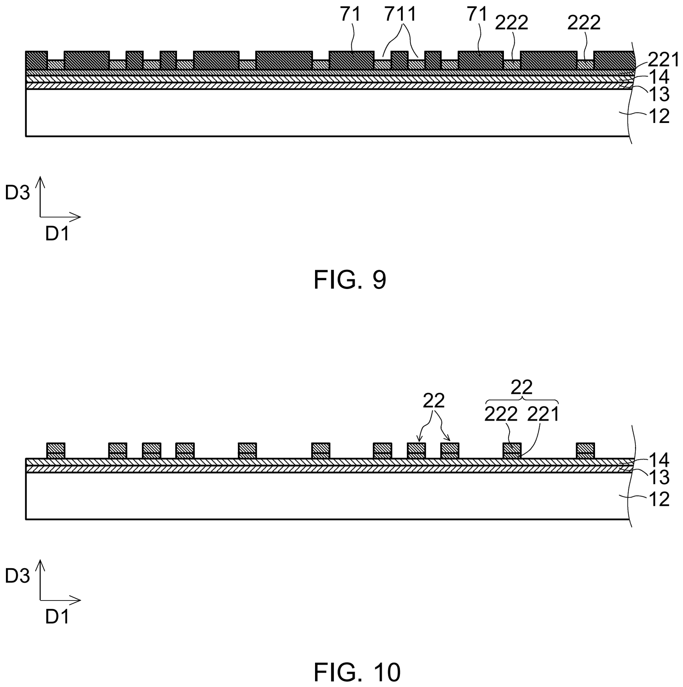

Subsequently, a plating step is performed. In the plating step, as illustrated in Fig. 9, a plating layer 222 is formed in the openings 711 through an electroplating process. Subsequently, as illustrated in Fig. 10, a step of removing the first resist layer 71 is performed. Subsequently, as illustrated in Fig. 10, a step of removing portions of the seed layer 221 that have been overlapping the first resist layer 71 is performed. Thus, electrically conductive layers 22 each including the seed layer 221 and the plating layer 222 are obtained.

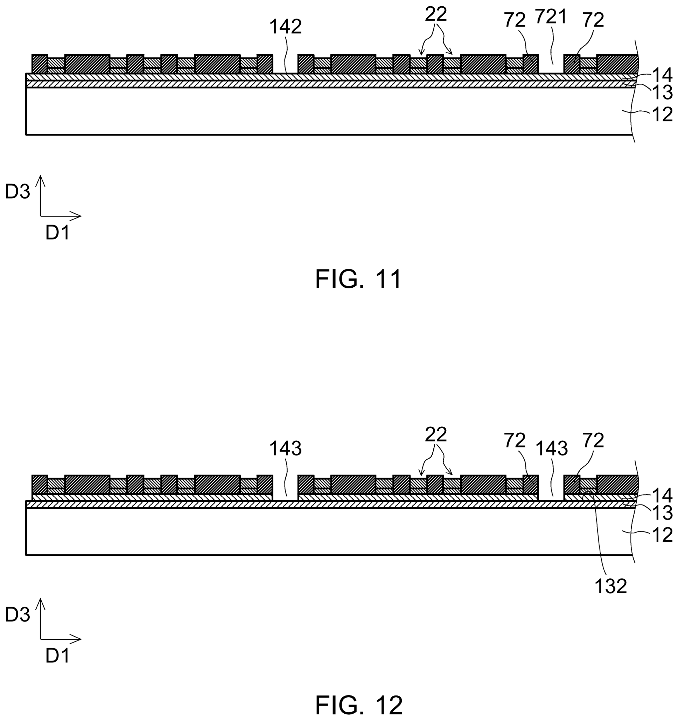

Subsequently, as illustrated in Fig. 11, a second resist layer 72 is formed on the second upper surface 142 of the intermediate layer 14. The second resist layer 72 has openings 721, which each extend through the second resist layer 72 in the thickness direction.

Subsequently, as illustrated in Fig. 12, a step of etching the intermediate layer 14 is performed. For example, portions of the intermediate layer 14 that are located at the openings 721 are removed through, for example, dry etching or wet etching. Thus, first openings 143 are made in the intermediate layer 14.

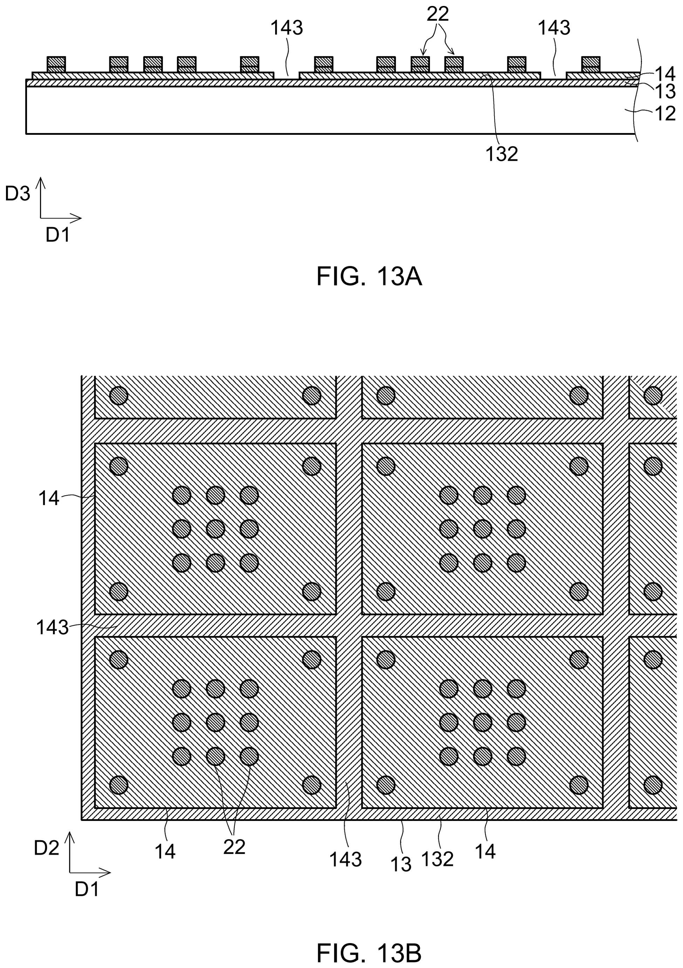

Subsequently, a step of removing the second resist layer 72 is performed. Figs. 13A and 13B illustrate in sectional view and plan view, respectively, the release layer 13, the intermediate layer 14, and the electrically conductive layers 22 obtained after the removal of the second resist layer 72. As illustrated in Figs. 13A and 13B, the first upper surface 132 of the release layer 13 is exposed at the first openings 143 of the intermediate layer 14.

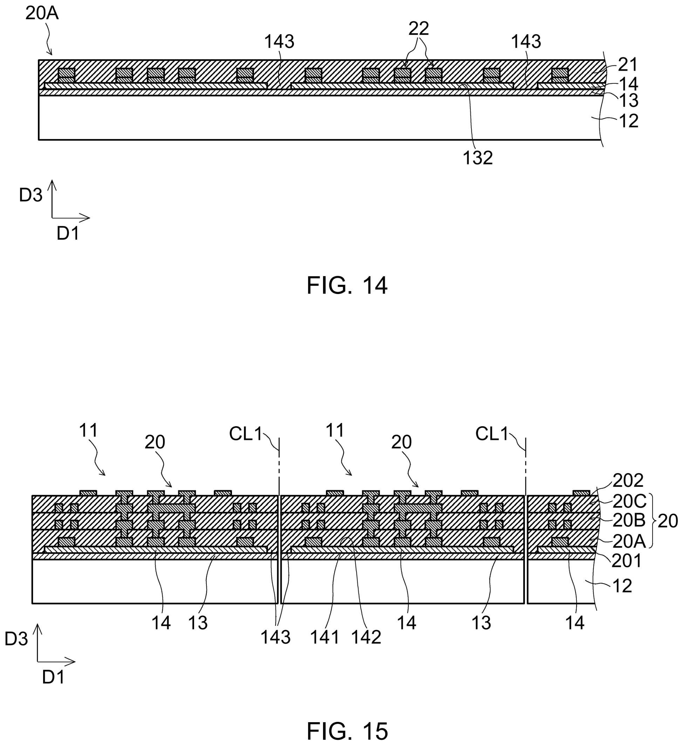

Subsequently, as illustrated in Fig. 14, a step of forming an insulating layer 21 is performed. The insulating layer 21 is formed in such a manner as to cover the intermediate layer 14 and the electrically conductive layers 22. Thus, a first wiring layer 20A including the insulating layer 21 and the electrically conductive layers 22 is obtained. Portions of the insulating layer 21 may be in contact with the first upper surface 132 of the release layer 13 at the first openings 143.

The step of forming the insulating layer 21 includes, for example, an application step of applying a solution containing resin and a solvent, and a drying step of evaporating the solvent after the application step. Examples of the solvent include propylene glycol monomethyl ether, 2-methoxy-1-methylethyl acetate, N-methyl-2-pyrrolidone, γ-butyrolactone, ethyl lactate, toluene, and the like. The drying step includes, for example, a step of heating the carrier substrate 12.

According to the present embodiment, since the intermediate layer 14 is formed on the release layer 13, the touching of the solvent to the release layer 13 during the step of forming the insulating layer 21 can be suppressed. Hence, the absorption of the solvent by the release layer 13 and the resulting swelling of the release layer 13 can be suppressed. The intermediate layer 14 includes openings such as the first opening 143. As described above, factors such as the areas and the dimensions of the openings are limited. Therefore, even if the solvent is absorbed by the release layer 13 through the first opening 143, the absorption can be minimized. Furthermore, as to be described below, the solvent absorbed by the release layer 13 can be discharged to the outside. Therefore, the absorption of the solvent by the release layer 13 through the first opening 143 can be made less likely to adversely affect the releasing step.

According to the present embodiment, since the intermediate layer 14 has the first opening 143, the gas generated inside the release layer 13 is more likely to be discharged through the opening 143. Therefore, the detachment of the intermediate layer 14 from the release layer 13 because of the gas during the process of manufacturing the wiring-substrate group 10 can be suppressed. Hence, the yield and the like in the process of manufacturing the wiring-substrate group 10 can be increased. The gas is generated inside the release layer 13 during, for example, a step of heating relevant elements of the wiring-substrate group 10. Examples of the step of heating relevant elements include a drying step of evaporating the solvent in the insulating layer 21, and a firing step of performing high-temperature heating.

After the first wiring layer 20A is formed, a step of forming a second wiring layer 20B and a third wiring layer 20C may be performed. Furthermore, a step of forming electrically conductive layers 22 constituting pads 24 and/or the like on the third wiring layer 20C may be performed. Thus, the wiring-substrate group 10 illustrated in Fig. 2 is obtained.

### (Method of Manufacturing Wiring Substrate)

A method of manufacturing the wiring substrate 11 and a method of using the wiring substrate 11 will now be described.

First, a wiring-substrate group 10 is prepared. Subsequently, as illustrated in Fig. 15, a dividing step of dividing it into wiring substrates 11 is performed. Thus, the plurality of wiring substrates 11 are obtained. Each wiring substrate 11 includes a carrier substrate 12; a release layer 13, which is located on the carrier substrate 12; an intermediate layer 14, which is located on the release layer 13; and a redistribution layer 20, which is located on the intermediate layer 14.

In the dividing step, the insulating layer 21 of the redistribution layer 20, the release layer 13, and the carrier substrate 12 may be cut along the boundary between each two of the redistribution layers 20 that are adjacent to each other in plan view. In Fig. 15, the two-dot chain lines denoted by reference sign CL1 each represent a cut position for the dividing step. The cut position CL1 may be located at the first opening 143 of the intermediate layer 14. In that case, the intermediate layer 14 is not cut.

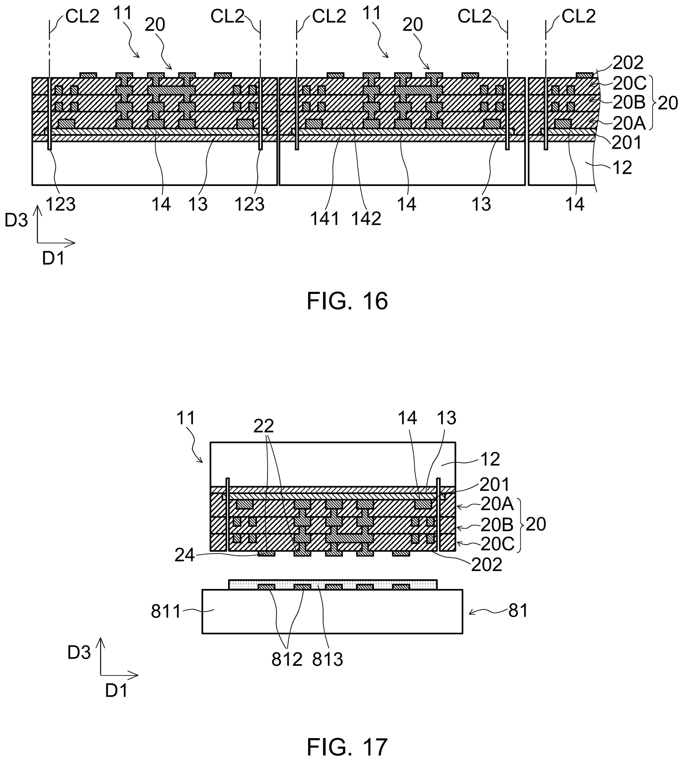

Subsequently, as illustrated in Fig. 16, a trimming step of removing an outer peripheral portion of each wiring substrate 11 may be preformed. In the trimming step, the outer peripheral portion of the wiring substrate 11 may be separated, through cutting, from a portion of the wiring substrate 11 that is located on the inner side relative to the outer peripheral portion. The trimming step may be omitted.

In Fig. 16, the two-dot chain lines denoted by reference sign CL2 each represent a cut position for the trimming step. The cut position CL2 may be located on the outer side relative to the electrically conductive layers 22 and overlap the release layer 13 and the intermediate layer 14. In that case, the insulating layer 21 of the redistribution layer 20, the release layer 13, and the intermediate layer 14 are cut. As illustrated in Fig. 16, the trimming step may be performed in such a manner as not to divide the carrier substrate 12.

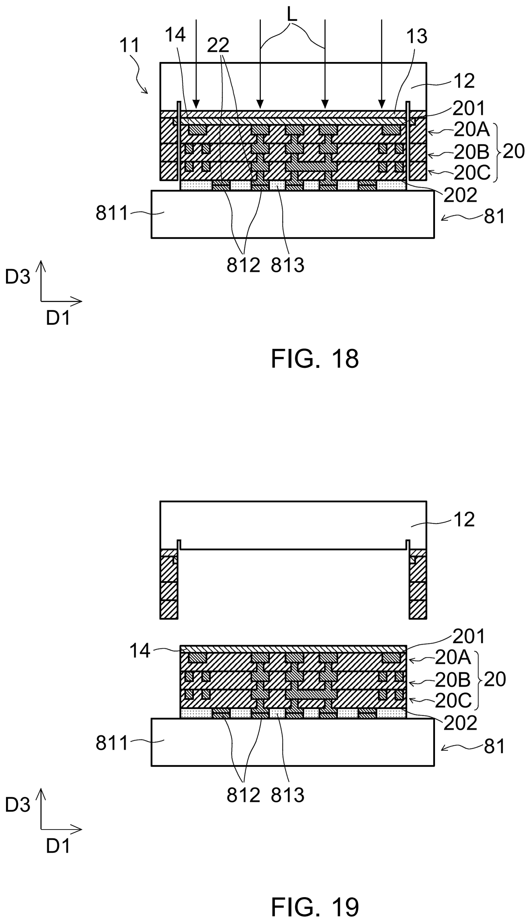

After the trimming step, as illustrated in Figs. 17 and 18, a first joining step may be performed in which the portion of the wiring substrate 11 that has been divided from the outer peripheral portion is joined to a first member 81. The first member 81 may include a substrate 811 and a plurality of terminals 812, which are located on the substrate 811. The first member 81 may include an adhesive layer 813, which covers the plurality of terminals. The adhesive layer 813 may alternatively be provided on the wiring substrate 11. In the first joining step, as illustrated in Fig. 18, those electrically conductive layers 22 that are located on the third upper surface 202 of the redistribution layer 20 and constitute pads 24 may be electrically connected to the terminals 812 of the first member 81.

Subsequently, as illustrated in Figs. 18 and 19, a releasing step of releasing the redistribution layer 20 from the carrier substrate 12 may be performed. As illustrated in Fig. 18, the releasing step may include an irradiation step of irradiating the release layer 13 with light L. In the irradiation step, the light L may reach the release layer 13 after being transmitted through the carrier substrate 12. The release layer 13 may be decomposed with heat generated by the irradiation with the light L. The decomposition leads to a reduction in the adhesiveness between the carrier substrate 12 and the intermediate layer 14. Therefore, as illustrated in Fig. 19, the carrier substrate 12 is separated from the intermediate layer 14 and the redistribution layer 20. Then, if there is any residue of the release layer 13 on the intermediate layer 14, a step of removing the residue may be performed.

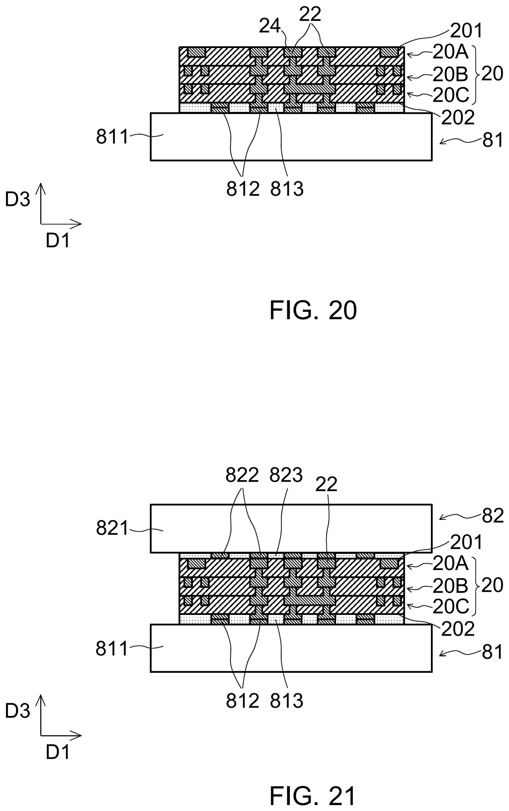

Subsequently, as illustrated in Fig. 20, a step of removing the intermediate layer 14 may be performed. For example, the intermediate layer 14 may be etched off. Removing the intermediate layer 14 exposes the third lower surface 201 of the redistribution layer 20. In such a case, the first wiring layer 20A constituting the third lower surface 201 may include a plurality of electrically conductive layers 22 constituting pads 24.

Subsequently, as illustrated in Fig. 21, a second joining step may be performed in which the electrically conductive layers 22 of the first wiring layer 20A of the wiring substrate 11 are joined to a second member 82. The second member 82 may include a substrate 821 and a plurality of terminals 822, which are located on the substrate 821. Between the substrate 821 of the second member 82 and the first wiring layer 20A of the wiring substrate 11 may be provided an adhesive layer 823.

The second member 82 may be a semiconductor device. The semiconductor device encompasses a transistor constituted by a semiconductor such as silicon. Examples of the semiconductor device include a CPU, a GPU, an FPGA, a sensor, a memory, and the like. The semiconductor device may be in the form of chiplets, which are separate semiconductor devices having respective functions of a CPU, a GPU, an FPGA, a sensor, a memory, and the like.

According to the present embodiment, the intermediate layer 14 can suppress the light L reaching the redistribution layer 20 in the releasing step. Thus, for example, a change in the state of the insulating layer 21 of the redistribution layer 20 because of the light irradiation can be suppressed.

According to the present embodiment, the intermediate layer 14 can suppress the propagation, to the redistribution layer 20, of the change in the state of the release layer 13 with the light irradiation in the releasing step or any other factor. Thus, for example, the change in the state of the insulating layer 21 of the redistribution layer 20 can be suppressed.

According to the present embodiment, the intermediate layer 14 can suppress the close adhesion between the insulating layer 21 of the redistribution layer 20 and the release layer 13. Thus, the redistribution layer 20 can be easily released from the release layer 13 in the releasing step.

The one embodiment described above can be changed in various ways. Such variations will now be described with reference to the drawings according to need. In the following description and the drawings to be referred to below, elements that can be configured as in the embodiment described above are denoted by the same reference signs as those used for corresponding ones of the elements according to the one embodiment described above. Redundant descriptions are omitted. If it is obvious that the functional effects obtained by the one embodiment described above can also be obtained by the variations, description of such effects may be omitted.

### (First Variation)

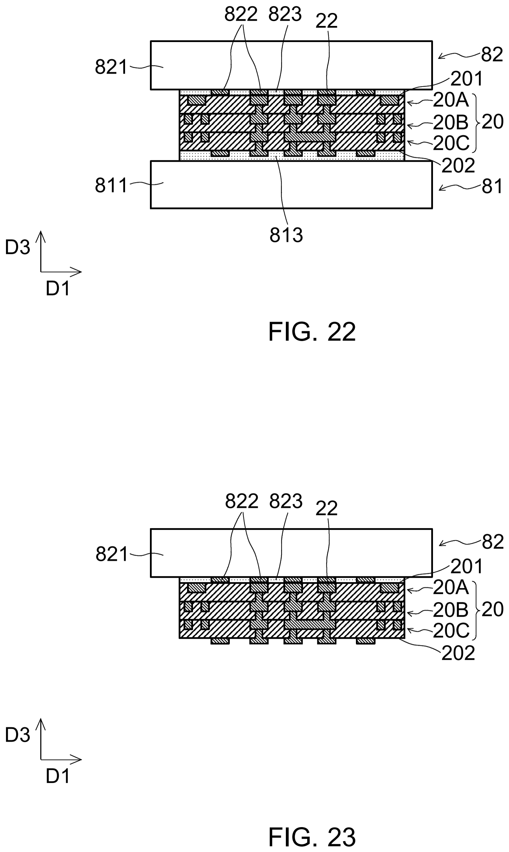

While the above embodiment has described an example in which the first member 81 includes the terminals 812 to be connected to the electrically conductive layers 22 of the redistribution layer 20, the first member 81 may be configured in any way. For example, as illustrated in Fig. 22, the first member 81 may include no terminals 812. In such a configuration, as illustrated in Fig. 23, after the third lower surface 201 of the redistribution layer 20 is joined to the second member 82, the first member 81 may be released from the redistribution layer 20.

After the first member 81 is released, a third member, which is not illustrated, may be joined to the third upper surface 202 of the redistribution layer 20. The third member may be a wiring substrate including a substrate and terminals. The third member may be a semiconductor device. The semiconductor device may include terminals to be electrically connected to the electrically conductive layers 22 located on the third upper surface 202 of the redistribution layer 20.

### (Second Variation)

The above embodiment has described an example in which the first opening 143 is made in the intermediate layer 14 after the electrically conductive layers 22 of the first wiring layer 20A are formed. The present variation describes an example in which the first opening 143 is made in the intermediate layer 14 before the electrically conductive layers 22 of the first wiring layer 20A are formed.

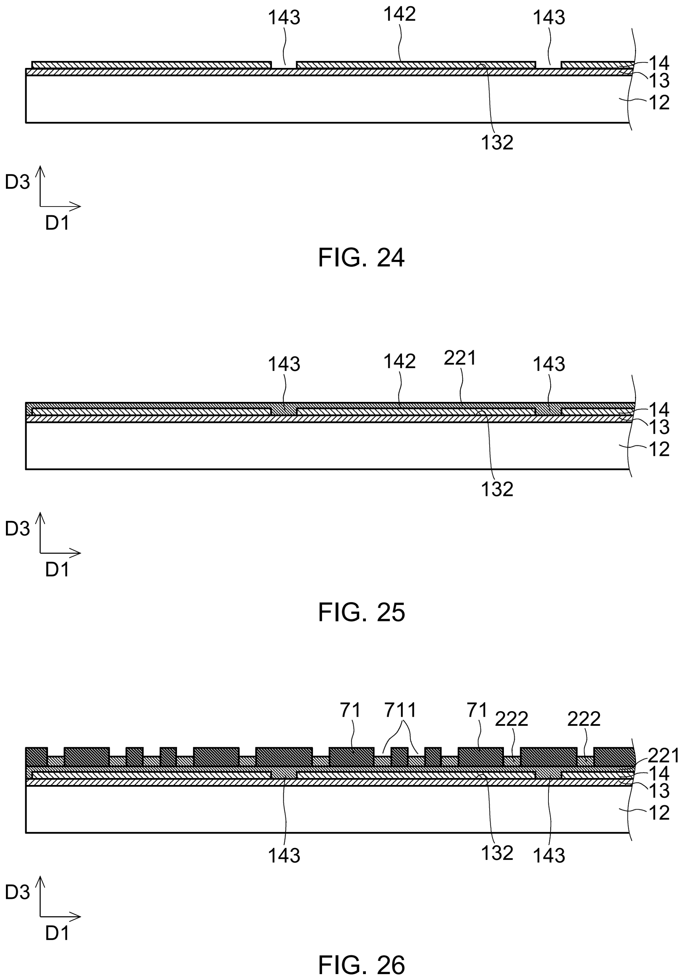

First, as in the above embodiment illustrated in Figs. 6 and 7, a release layer 13 and an intermediate layer 14 are formed on the carrier substrate 12. Subsequently, as illustrated in Fig. 24, first openings 143 are made in the intermediate layer 14. For example, a second resist layer 72, described above, is first formed on the second upper surface 142 of the intermediate layer 14. Subsequently, a step of etching the intermediate layer 14 is performed. For example, portions of the intermediate layer 14 that are located at openings 721 are removed through dry etching. Thus, first openings 143 are made in the intermediate layer 14.

Subsequently, as illustrated in Fig. 25, a step of forming a seed layer 221 on the second upper surface 142 of the intermediate layer 14 is performed. The seed layer 221 may be formed in the first openings 143 as well.

Subsequently, as illustrated in Fig. 26, a first resist layer 71 is formed on the seed layer 221. Subsequently, as illustrated in Fig. 26, a plating layer 222 is formed in openings 711 through an electroplating process. Subsequently, a step of removing the first resist layer 71 is performed. Subsequently, a step of removing portions of the seed layer 221 that have been overlapping the first resist layer 71 is performed. Thus, electrically conductive layers 22 each including the seed layer 221 and the plating layer 222 are obtained.

### (Third Variation)

The above embodiment has described an example in which the intermediate layer 14 has openings each located at the boundary between the first wiring layers 20A of corresponding two of the redistribution layers 20 that are adjacent to each other in plan view. The present variation describes an example in which the intermediate layer 14 has openings that are located in a region of the first wiring layer 20A of the redistribution layer 20 where the electrically conductive layers 22 are distributed. The openings of the intermediate layer 14 that are located in the second region 21B are also referred to as second openings and are denoted by reference sign 144.

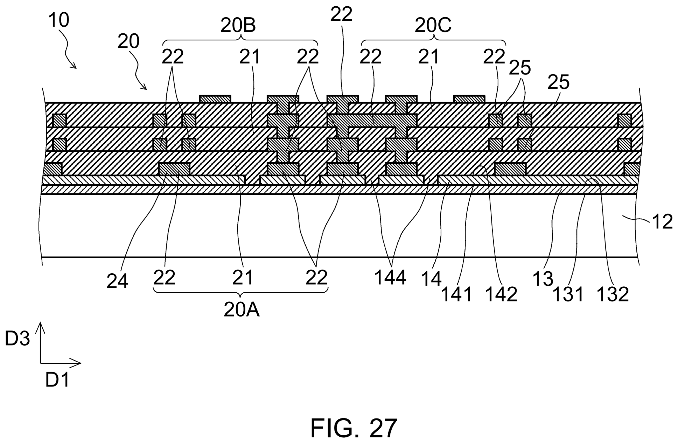

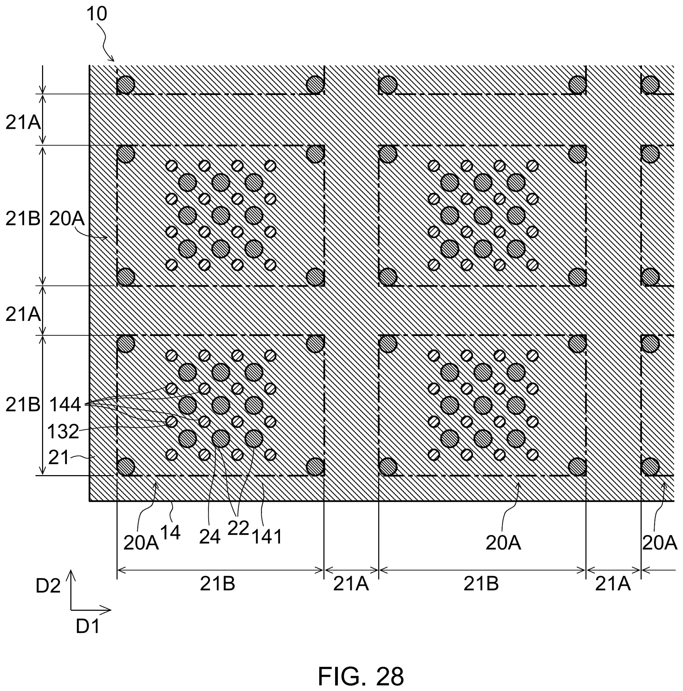

Fig. 27 is a sectional view of a wiring-substrate group 10 according to the present variation. Fig. 28 illustrates in plan view a positional relationship among the release layer 13, the intermediate layer 14, and the first wiring layer 20A of the wiring-substrate group 10 according to the present variation. The wiring-substrate group 10 has a plurality of second openings 144, which overlap in plan view the second region 21B of the insulating layer 21 of the first wiring layer 20A.

As illustrated in Fig. 28, the first wiring layer 20A may include a plurality of electrically conductive layers 22, which are arranged regularly in the planar direction and constitute pads 24. The plurality of second openings 144 may include at least a one that is located between two of the pads 24 that are adjacent to each other in plan view.

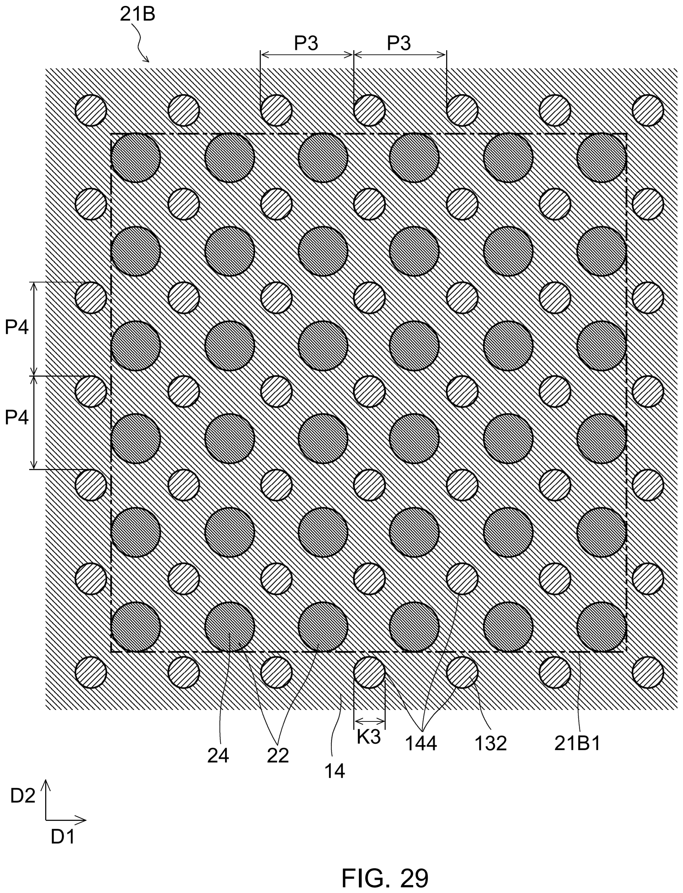

The plurality of second openings 144 may be arranged regularly in the planar direction, as with the plurality of electrically conductive layers 22 constituting the pads 24. For example, the plurality of second openings 144 may be arranged regularly in a first opening-arrangement direction and in a second opening-arrangement direction, which is orthogonal to the first opening-arrangement direction. In the example illustrated in Fig. 29, the first opening-arrangement direction and the second opening-arrangement direction coincide with the first direction D1 and the second direction D2, respectively. The plurality of electrically conductive layers 22 constituting the pads 24 may include at least a one that is located between two of the second openings 144 that are adjacent to each other in plan view.

In Fig. 29, reference sign P3 denotes the arrangement pitch of the second openings 144 in the first opening-arrangement direction, and reference sign P4 denotes the arrangement pitch of the second openings 144 in the second opening-arrangement direction. The arrangement pitches P3 and P4 are each, for example, 500 µm or less and may be 300 µm or less, 100 µm or less, or 50 µm or less.

Fig. 29 illustrates in enlarged plan view the release layer 13, the intermediate layer 14, and the electrically conductive layers 22 that overlap the second region 21B. The second region 21B may include a first second region 21B1. The first second region 21B1 is located in a region where the plurality of electrically conductive layers 22 constituting the pads 24 of the first wiring layer 20A are regularly arranged. The outline of the first second region 21B1 is defined by a virtual rectangle enclosing the plurality of pads 24 that are regularly arranged. The region enclosed by the rectangle is the first second region 21B1. Each of the sides of the rectangle circumscribes corresponding ones of the electrically conductive layers 22 constituting the pads 24. The plurality of second openings 144 may include at least a one that is located in the first second region 21B1 in plan view.

In Fig. 29, reference sign K3 denotes a dimension of each of the second openings 144 in the planar direction. The dimension K3 is defined in such a direction that the dimension of the second openings 144 is maximized. The dimension K3 of the second openings 144 is, for example, 0.1 µm or more and may be 0.2 µm or more. Thus, the gas generated inside the release layer 13 is appropriately discharged through the second openings 144. The dimension K3 of the second openings 144 is, for example, 50 µm or less and may be 30 µm or less, 10 µm or less, 3 µm or less, or 1 µm or less. Thus, the deterioration of any of the first to fourth functions of the intermediate layer 14 described above and/or the like can be suppressed.

The dimension K3 of the second openings 144 may be defined relative to the arrangement pitches P3 and P4 of the second openings 144. The ratio, K3/P3, of the dimension K3 to the arrangement pitch P3 is, for example, 0.0010 or more and may be 0.0030 or more or 0.010 or more. K3/P3 is, for example, 0.10 or less and may be 0.050 or less or 0.020 or less. The numerical range of K3/P3 can also be taken as the numerical range of the ratio, K3/P4, of the dimension K3 to the arrangement pitch P4.

The total area, AR2, of the plurality of second openings 144 may be defined relative to the area, AR1, of the first second region 21B1. The total area AR2 is the sum of the areas of the plurality of second openings 144 overlapping the first second region 21B1. The ratio, AR2/AR1, of the total area AR2 of the second openings 144 to the area AR1 of the first second region 21B1 is, for example, 0.0010 or more and may be 0.0030 or more or 0.010 or more. AR2/AR1 is, for example, 0.10 or less and may be 0.050 or less or 0.020 or less. AR2/AR1 is also referred to as the opening ratio of the second openings 144.

The number, N2, of the second openings 144 overlapping the first second region 21B1 may be defined relative to the number, N1, of the electrically conductive layers 22 overlapping the first second region 21B1. The ratio, N2/N1, of the number N2 of the second openings 144 to the number N1 of the electrically conductive layers 22 is, for example, 0.5 or more and may be 0.7 or more or 1.0 or more. N2/N1 is, for example, 5.0 or less and may be 4.0 or less or 3.0 or less.

### (Fourth Variation)

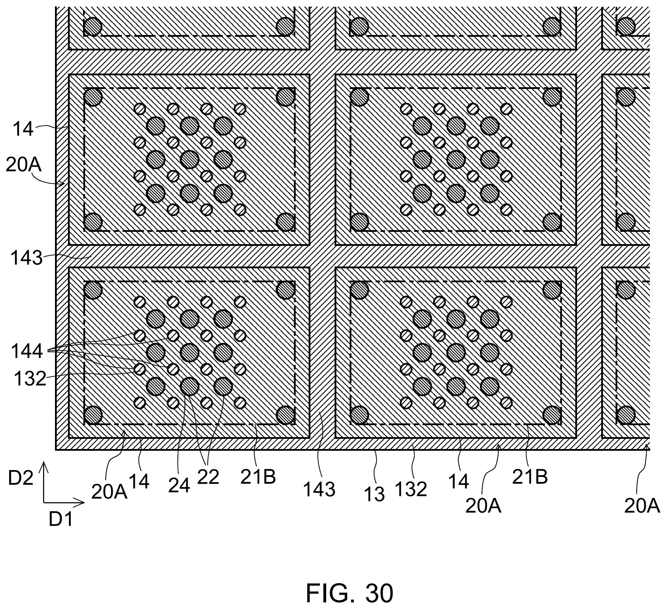

Fig. 30 is a plan view of a wiring-substrate group 10 according to the present variation. The openings of the intermediate layer 14 may include a first opening 143 and a plurality of second openings 144. Thus, the detachment of the intermediate layer 14 from the release layer 13 because of the gas generated inside the release layer 13 can be suppressed more assuredly.

### (Fifth Variation)

The above embodiment and variations have described an example in which the openings of the intermediate layer 14 are located outside the outlines of the electrically conductive layers 22 of the first wiring layer 20A in plan view. The present variation describes an example in which the openings of the intermediate layer 14 are located inside the outlines of the electrically conductive layers 22 of the first wiring layer 20A in plan view.

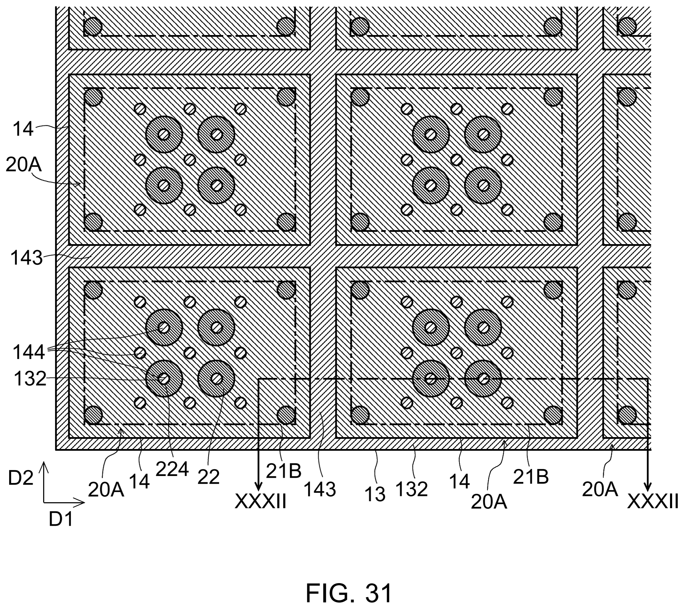

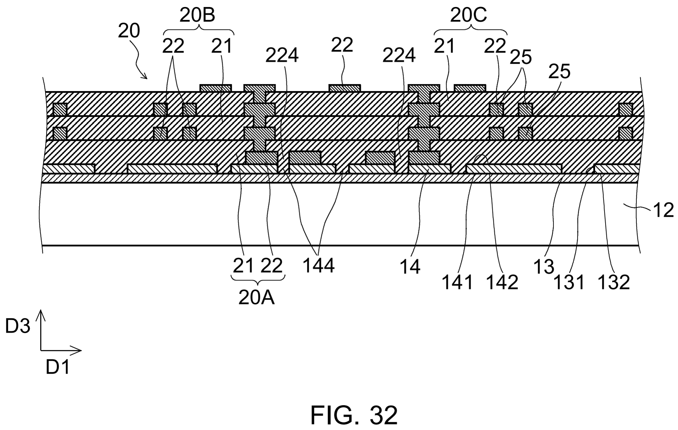

Fig. 31 is a plan view of a wiring-substrate group 10 according to the present variation. Fig. 32 is a sectional view of the wiring-substrate group 10 illustrated in Fig. 31, taken along line XXXII-XXXII. The openings of the intermediate layer 144 may include second openings 144 located inside the outlines of the electrically conductive layers 22 of the first wiring layer 20A in plan view. In other words, the openings of the intermediate layer 14 may include second openings 144 each enclosed by a corresponding one of the electrically conductive layers 22 of the first wiring layer 20A in plan view.

The openings of the intermediate layer 14 may further include second openings 144 located outside the outlines of the electrically conductive layers 22 of the first wiring layer 20A in plan view. The openings of the intermediate layer 14 may further include a first opening 143.

As illustrated in Figs. 31 and 32, the electrically conductive layers 22 of the first wiring layer 20A may each have an opening 224, which coincides with a corresponding one of the second openings 144 in plan view. The opening 224 extends through the electrically conductive layer 22. Therefore, the gas generated inside the release layer 13 is discharged to the outside of the wiring-substrate group 10 through the second openings 144 of the intermediate layer 14, the openings 224 of the electrically conductive layers 22, and the insulating layer 21.

### (Sixth Variation)

The above embodiment has described an example in which the electrically conductive layers 22 each include a seed layer 221. The present variation describes an example in which the electrically conductive layers 22 each include no seed layer 221.

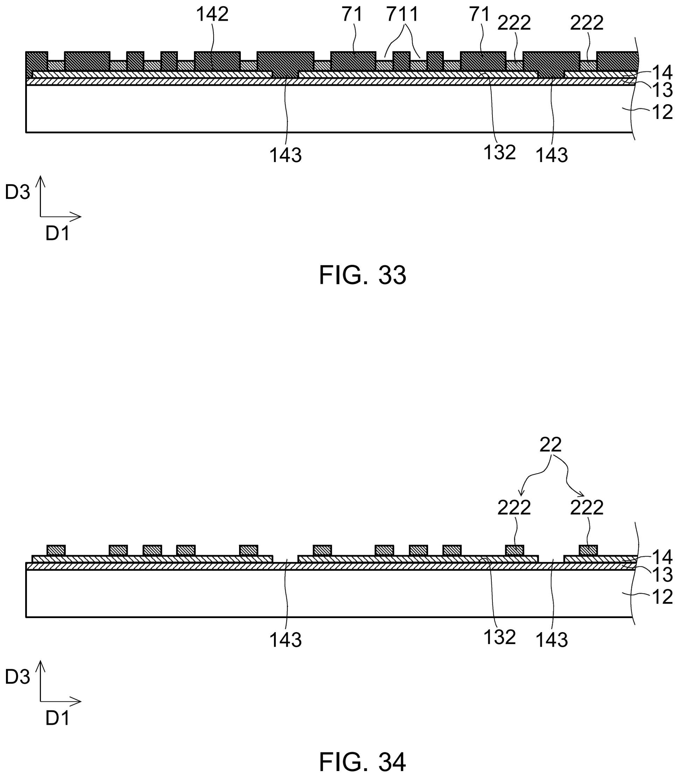

Fig. 33 illustrates in sectional view a step of forming a plating layer 222. In the present variation, the first resist layer 71 is formed on the second upper surface 142 of the intermediate layer 14. As illustrated in Fig. 33, a plating layer 22 is formed in the openings 711 through an electroplating process. Subsequently, as illustrated in Fig. 34, a step of removing the first resist layer 71 is performed. Thus, electrically conductive layers 22 each constituted by the plating layer 222 are formed on the second upper surface 142 of the intermediate layer 14.

Figs. 33 and 34 illustrate an example in which first openings 143 are made in the intermediate layer 14 before the plating layer 222 is formed. In an example not illustrated, first openings 143 may be made in the intermediate layer 14 after the plating layer 222 is formed on the second upper surface 142 of the intermediate layer 14.

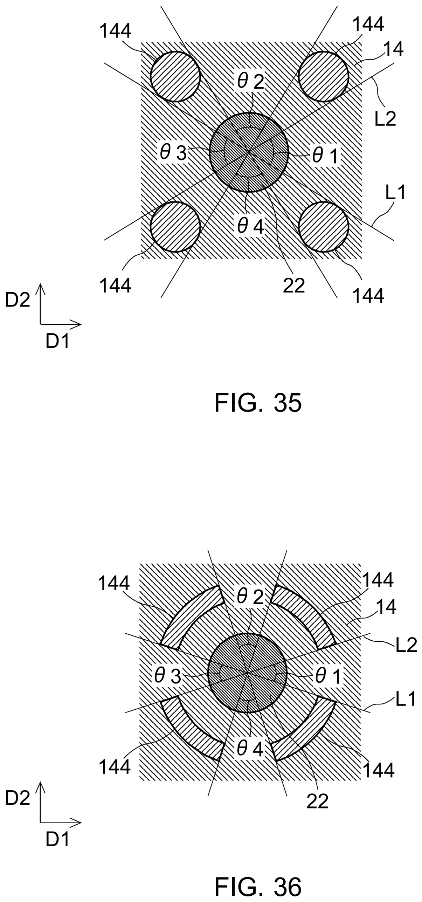

In the example in which first openings 143 are made in the intermediate layer 14 before the plating layer 222 is formed, it is preferable to arrange the first openings 143 such that a satisfactory path for the electric current to be supplied to the plating layer 222 be assuredly provided. Fig. 35 illustrates in plan view an exemplary positional relationship between an electrically conductive layer 22 constituted by the plating layer 222 and second openings 144 provided in the intermediate layer 14.

The electric current to be supplied to the plating layer 222 is considered to have a correlation with the sum, θ0, of supply angles θ1 to θ4, which are illustrated in Fig. 35. The supply angle is defined on the basis of a positional relationship between a single electrically conductive layer 22 and a plurality of second openings 144 located near the single electrically conductive layer 22 in plan view. In Fig. 35, four second openings 144 are located near a single electrically conductive layer 22. The four second openings 144 are at an equal distance from the electrically conductive layer 22. The supply angle is defined as an angle formed between two virtual straight lines L1 and L2, which each passes through the central point of the electrically conductive layer 22 and are tangent to two respective ones of the openings 144 that are adjacent to each other. For example, the supply angle θ1 is an angle formed between a straight line L1 passing through the central point of the electrically conductive layer 22 and being tangent to a first second opening 144 and a straight line L2 passing through the central point of the electrically conductive layer 22 and being tangent to a second opening 144 that is adjacent to the first second opening 144. The supply angles θ2 to θ4 illustrated in Fig. 35 are defined in the same manner as above.

The sum θ0 of the supply angles is, for example, 60° or more and may be 90° or more or 120° or more. Thus, a satisfactory path for the electric current to be supplied to the plating layer 222 can be assuredly provided. The sum θ0 of the supply angles is, for example, 300° or less and may be 240° or less or 180° or less.

Fig. 36 illustrates in plan view an exemplary positional relationship between an electrically conductive layer 22 constituted by the plating layer 222 and the second openings 144 provided in the intermediate layer 14. In a case where the electrically conductive layer 22 has a circular shape in plan view as illustrated in Fig. 35, the second openings 144 of the intermediate layer 14 may each have a shape extending in the circumferential direction of the electrically conductive layer 22. In the example illustrated in Fig. 36 as well, the sum θ0 of the supply angles is within the above numerical range. Therefore, a satisfactory path for the electric current to be supplied to the plating layer 222 can be assuredly provided.

### (Seventh Variation)

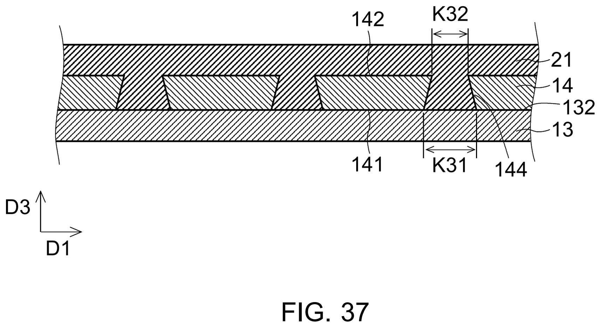

Fig. 37 illustrates in sectional view exemplary second openings 144 of the intermediate layer 14 according to the present variation. Reference sign K31 denotes the dimension of each second opening 144 at the second lower surface 141. Reference sign K32 denotes the dimension of the second opening 144 at the second upper surface 142. The dimension K32 may be smaller than the dimension K31. Thus, light transmitted through the release layer 13 and entered the second opening 144 can be made less likely to reach the second upper surface 142.

The dimension of the second opening 144 may become smaller toward the second upper surface 142 in the thickness direction. Such a shape of the second opening 144 can be realized by, for example, performing dry etching in forming the second opening 144 in the intermediate layer 14.

The ratio, K32/K31, of the dimension K32 to the dimension K31 is, for example, 0.90 or less and may be 0.80 or less or 0.70 or less. K32/K31 is, for example, 0.30 or more and may be 0.40 or more or 0.50 or more.

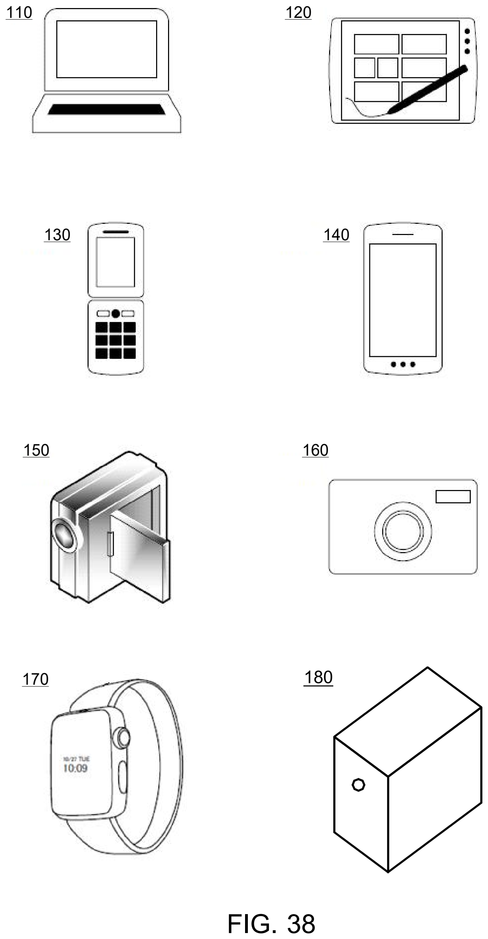

Fig. 38 illustrates exemplary products each including the wiring substrate 11 or the redistribution layer 20. The wiring substrate 11 or the redistribution layer 20 may be used in various products. For example, the wiring substrate 11 or the redistribution layer 20 is included in any of a laptop personal computer 110, a tablet terminal 120, a mobile phone 130, a smartphone 140, a digital video camera 150, a digital camera 160, a digital watch 170, a server 180, and so forth.

While some variations of the above embodiment have been described, some of the variations can be combined according to need to be applied to the above embodiment, of course.

### EXAMPLES

Now, the first embodiment of the present disclosure will further be described specifically with a working example. Embodiments of the present disclosure is not limited to the following working example, without departing from the essence thereof.

### (WORKING EXAMPLE 1)

A wiring-substrate group 10, illustrated in Fig. 30, in which the intermediate layer 14 includes a first opening 143 and a plurality of second openings 144 was manufactured. The material used for the release layer 13 was a material capable of separating the intermediate layer 14 and the redistribution layer 20 from the carrier substrate 12 through the irradiation of the release layer 13 with light. The material used for the insulating layer 21 was polyimide. The step of forming the insulating layer 21 included a step of heating the insulating layer 21 at 200°C. The material used for the intermediate layer 14 was titanium. The material used for the electrically conductive layers 22 was copper.

The second openings 144 each had a circular shape in plan view with a diameter of 30 µm. The plurality of second openings 144 were arranged at an arrangement pitch of 130 µm in the first opening-arrangement direction and in the second opening-arrangement direction. The opening ratio of the second openings 144 was 0.042. The width of the first opening 143 was 200 µm.

In Working Example 1, after the redistribution layers 20 were formed, neither bubbles nor detachment was confirmed at the interface between the release layer 13 and the intermediate layer 14.

Subsequently, as illustrated in Figs. 18 and 19, the release layer 13 was irradiated with ultraviolet light, which allowed the redistribution layers 20 to be separated from the carrier substrate 12.

### (COMPARATIVE EXAMPLE 1)

A wiring-substrate group 10 was manufactured in the same manner as for Working Example 1, except that neither a first opening 143 nor a plurality of second openings 144 were made in the intermediate layer 14. In Comparative Example 1, after the redistribution layers 20 were formed, bubbles and detachment were confirmed at the interface between the release layer 13 and the intermediate layer 14.

### (Second Embodiment)

A second embodiment is based on and claims priority to Japanese Patent Application No. 2023-6077 filed on January 18, 2023. The second embodiment relates to a method of manufacturing a redistribution layer and to a wiring-substrate group. The names of the elements in the specification of Japanese Patent Application No. 2023-6077 are changed in the present application as summarized in Table 1 below.

**[Table 1]**

| Name in JP No. 2023-006077 | Name in the present application |
|---|---|
| interposer halfway body | wiring-substrate group |
| individuated interposer halfway body | wiring substrate |
| intermediate interposer layer | redistribution-layer group |
| interposer | redistribution layer |
| first resin wiring layer | first wiring layer |
| second resin wiring layer | second wiring layer |
| third resin wiring layer | third wiring layer |
| resin layer | insulating layer |
| light-blocking layer | intermediate layer |
| BGA | first member |
| substrate body | substrate |
| adhesive material | adhesive layer |

As described above, the redistribution layers are each cut out of the wiring-substrate group together with a portion of the carrier substrate. The cutting is also referred to as individuation. Each redistribution layer is released from a corresponding piece of the carrier substrate when being incorporated into, for example, a semiconductor package.

In a case where the operation of releasing the redistribution layer from a piece of the carrier substrate is planned to be performed, a release layer is usually provided on the carrier substrate that is yet to be individuated and a plurality of redistribution layers are collectively formed on the release layer. The release layer may contain, for example, polyimide. If the release layer contains polyimide, the release of the redistribution layer from the piece of the carrier substrate can be achieved by, for example, irradiating the release layer with light through the piece of the carrier substrate.

In a case where the release layer is provided on the carrier substrate, a desired adhesive strength may not necessarily be provided at the interface between the carrier substrate and the release layer.

For example, if the carrier substrate has a smooth surface or if the carrier substrate is made of an inorganic material while the release layer is made of an organic material, it may be difficult to provide a desired adhesive strength. If the adhesive strength between the carrier substrate and the release layer is insufficient, the risk of detachment of the release layer from the carrier substrate increases. The release layer particularly tends to be detached from the carrier substrate when, for example, the redistribution layer is cut out.

The second embodiment of the present disclosure is to provide a method of manufacturing a redistribution layer, and a wiring-substrate group that can effectively solve the above problem.

The second embodiment of the present disclosure relates to [1] to [18] below.

[1] A method of manufacturing a redistribution layer, comprising:
   an adhesive-layer-forming step of providing an adhesive layer on a first surface of a carrier substrate, the carrier substrate including the first surface and a second surface, the second surface being located opposite the first surface;
   a release-layer-forming step of providing a release layer on a surface of the adhesive layer, the surface being located opposite an other surface of the adhesive layer, the other surface being in contact with the first surface, the release layer containing resin;
   a redistribution-layer-forming step of releasably providing one or a plurality of redistribution layers on a surface of the release layer, the surface being located opposite an other surface of the release layer, the other surface being in contact with the adhesive layer, the one or the plurality of redistribution layers each including a wire and an insulating layer, the insulating layer covering the wire and containing resin; and
   a release-treatment step of making the redistribution layers releasable from the carrier substrate and the adhesive layer by irradiating the release layer with laser light through the adhesive layer, the laser light being received at the second surface and transmitted through the first surface.
[2] The method of manufacturing a redistribution layer according to [1], further comprising:
   an individuation step of cutting out the redistribution layer together with a portion of the carrier substrate from the carrier substrate and the one or the plurality of redistribution layers provided on the carrier substrate;
   wherein in the release-treatment step, the redistribution layer is made releasable from the portion of the carrier substrate and the adhesive layer on the portion of the carrier substrate by irradiating with the laser light the release layer located between the redistribution layer and the portion of the carrier substrate obtained in the individuation step.
[3] The method of manufacturing a redistribution layer according to [2], further comprising:
   a trimming step that is performed on the redistribution layer and the portion of the carrier substrate obtained in the individuation step, and in which an outer peripheral portion of the redistribution layer is separated from an inner portion relative to the outer peripheral portion by making an incision extending through the redistribution layer and reaching a halfway position of the carrier substrate in a direction in which the redistribution layer and the portion of the carrier substrate overlap each other,
   wherein in the release-treatment step, the redistribution layer is made releasable from the portion of the carrier substrate and the adhesive layer on the portion of the carrier substrate by irradiating with the laser light the release layer located between at least the inner portion of the redistribution layer and the portion of the carrier substrate that are obtained after the trimming step.
[4] The method of manufacturing a redistribution layer according to any of [1] to [3], wherein the adhesive layer is formed through a CVD method.
[5] The method of manufacturing a redistribution layer according to any of [1] to [4], wherein the carrier substrate and the adhesive layer contain an identical material.
[6] The method of manufacturing a redistribution layer according to any of [1] to [5], wherein the carrier substrate and the adhesive layer have different refractive indices from each other.
[7] The method of manufacturing a redistribution layer according to any of [1] to [6], wherein the adhesive layer contains silicon dioxide.
[8] The method of manufacturing a redistribution layer according to any of [1] to [7], wherein the adhesive layer is constituted by only a layer containing silicon dioxide as a chief component.
[9] The method of manufacturing a redistribution layer according to any of [1] to [7],
   wherein the adhesive layer includes a first portion joined to the first surface; and a second portion provided over the first portion, and
   wherein the first portion contains silicon nitride as a chief component, while the second portion contains the silicon dioxide as a chief component.
[10] The method of manufacturing a redistribution layer according to any of [1] to [9], wherein the carrier substrate contains silicon dioxide.
[11] The method of manufacturing a redistribution layer according to any of [1] to [10], wherein the adhesive layer is composed in such a manner as to have a transmissivity of 90% or more with respect to the laser light.
[12] The method of manufacturing a redistribution layer according to [11], wherein the laser light has a wavelength of 355 nm.
[13] The method of manufacturing a redistribution layer according to any of [1] to [12], wherein the adhesive layer has an arithmetic mean height of 0.01 µm or more and 0.1 µm or less.
[14] The method of manufacturing a redistribution layer according to any of [1] to [13], wherein the release layer contains polyimide.
[15] The method of manufacturing a redistribution layer according to any of [1] to [14], further comprising an intermediate-layer-forming step of providing an intermediate layer between the release layer and the redistribution layer, the intermediate layer limiting transmission of the laser light.
[16] The method of manufacturing a redistribution layer according to [15], wherein the intermediate layer contains at least one kind among titanium, gold, silver, nickel, and copper.
[17] The method of manufacturing a redistribution layer according to [15] or [16], wherein the intermediate layer is composed in such a manner as to have a reflectivity of 90% or more with respect to the laser light.
[18] A wiring-substrate group comprising:
   a carrier substrate including a first surface and a second surface, the second surface being located opposite the first surface;
   an adhesive layer provided on the first surface,
   a release layer provided on a surface of the adhesive layer, the surface being located opposite an other surface of the adhesive layer, the other surface being in contact with the first surface, the release layer containing resin; and
   one or a plurality of redistribution layers releasably provided on a surface of the release layer, the surface being located opposite an other surface of the release layer, the other surface being in contact with the adhesive layer, the one or the plurality of redistribution layers each including a wire and an insulating layer, the insulating layer covering the wire and containing resin.

According to the second embodiment of the present disclosure, the detachment of the release layer can be suppressed.

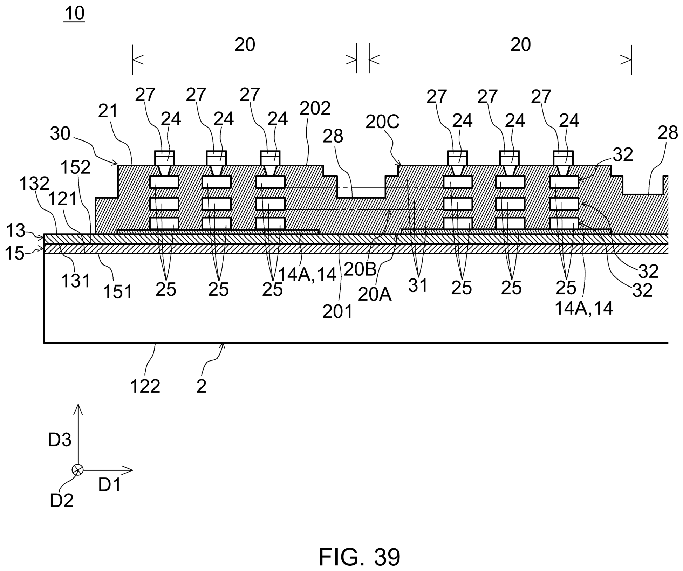

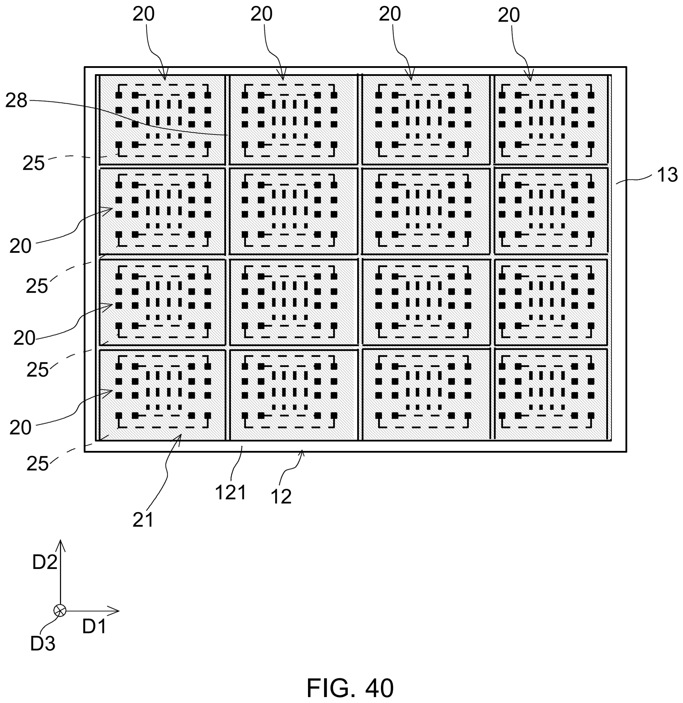

Fig. 39 is a schematic sectional view of a wiring-substrate group 10 for manufacturing a redistribution layer 20 in one example. Fig. 40 is a plan view of the wiring-substrate group 10. The wiring-substrate group 10 has a first direction D1, a second direction D2, and a third direction D3. The first direction D1 and the second direction D2 are included in the planar direction of the wiring-substrate group 10. The first direction D1 is orthogonal to the second direction D2. The third direction D3 is the thickness direction of the wiring-substrate group 10. The third direction D3 is orthogonal to the first direction D1 and to the second direction D2.

The wiring-substrate group 10 includes a carrier substrate 12, and one or a plurality of redistribution layers 20, which are releasably provided on the carrier substrate 12. In the present embodiment, a plurality of redistribution layers 20 are collectively provided on the carrier substrate 12. The plurality of redistribution layers 20 in the illustrated example are connected to one another in the first direction D1 or the second direction D2. Hereinafter, an element including a plurality of redistribution layers 20 that are connected to one another is referred to as a redistribution-layer group 30. That is, the redistribution-layer group 30 corresponds to a portion including a plurality of redistribution layers 20. The redistribution layers 20 are each a component that is cut out of the redistribution-layer group 30 in the manufacture of, for example, a semiconductor package and is to be incorporated into the semiconductor package. Individual elements of the wiring-substrate group 10 will now be described.

### (Carrier Substrate)

The carrier substrate 12 is a plate member and includes a first surface 121 and a second surface 122, which is located opposite the first surface 121. The carrier substrate 12 has a rectangular shape in plan view as illustrated in Fig. 40. The carrier substrate 12 may have another shape, such as a circular shape, in plan view.

The carrier substrate 12 in the present embodiment is a quartz substrate containing silicon dioxide (SiO₂) as a chief component. The carrier substrate 12 may be, for example, a glass substrate, a sapphire substrate, a silicon substrate, a silicon-carbide substrate, an alumina (Al2O3) substrate, an aluminum-nitride (AIN) substrate, a zirconium-oxide (ZrO2) substrate, a lithium-niobate substrate, a tantalum-niobate substrate, or the like. The carrier substrate 12 may include two or more kinds among the following: a quartz substrate, a glass substrate, a sapphire substrate, a silicon substrate, a silicon-carbide substrate, an alumina (Al2O3) substrate, an aluminum-nitride (AlN) substrate, a zirconium-oxide (ZrO2) substrate, a lithium-niobate substrate, a tantalum-niobate substrate, and a resin substrate. The resin substrate may contain an organic material. For example, the resin substrate may contain epoxy resin, polyethylene, polypropylene, or the like.

The thickness of the carrier substrate 12 is, for example, 100 µm or more and may be 200 µm or more or 500 µm or more. The thickness of the carrier substrate 12 is, for example, 2 mm or less and may be 1.5 mm or less or 1 mm or less. The area of the carrier substrate 12 is, for example, 0.5 m² or more and may be 1.0 m² or more, 2.0 m² or more, or 3.0 m² or more.

The redistribution-layer group 30 (plurality of redistribution layers 20) is provided on the carrier substrate 12 with an adhesive layer 15 and a release layer 13 in between. The adhesive layer 15 and the release layer 13 are provided in that order on the first surface 121 of the carrier substrate 12. The adhesive layer 15 has surface properties that are different from the surface properties of the first surface 121. Surface properties refer to at least one of properties such as surface roughness, surface composition, surface wettability, and the like. Specifically, the surface of the adhesive layer 15 in the present embodiment is rougher than at least the first surface 121 of the carrier substrate 12. More specifically, the arithmetic mean height of the adhesive layer 15 is greater than the arithmetic mean height of the first surface 121. The arithmetic mean height of the adhesive layer 15 is, for example, 0.01 µm or more and 0.1 µm or less. Arithmetic mean height is a value calculated in accordance with JIS B 0601:2013.

The adhesive layer 15 contains silicon dioxide (SiO₂) as a chief component. Specifically, the adhesive layer 15 is constituted by only a layer containing silicon dioxide as a chief component. The adhesive layer 15 is provided for increasing the adhesive strength between the release layer 13 and the carrier substrate 12 described above. In the present embodiment, the adhesive layer 15 is constituted by only a layer containing silicon dioxide as a chief component, and the carrier substrate 12 and the adhesive layer 15 contain an identical material.

As long as a desirable level of adhesive strength is provided between the release layer 13 and the carrier substrate 12, the material and/or components of the adhesive layer 15 are not limited. For example, the adhesive layer 15 may include a first portion joined to the first surface 121 of the carrier substrate 12, and a second portion provided over the first portion. The first portion may contain silicon nitride as a chief component, and the second portion may contain silicon dioxide as a chief component.

In the present embodiment, the adhesive layer 15 is formed through a CVD (chemical vapor deposition) method. Thus, in the present embodiment, the arithmetic mean height of the adhesive layer 15 becomes greater than the arithmetic mean height of the first surface 121 of the carrier substrate 12. That is, the use of a CVD method makes the surface of the adhesive layer 15 rougher than the first surface 121 of the carrier substrate 12, which has been polished for smoothness. Specifically, while the adhesive layer 15 in the present embodiment is formed through a plasma CVD method, the adhesive layer 15 may alternatively be formed through a thermal CVD method. The adhesive layer 15 may be formed through vapor deposition or sputtering.

In the present embodiment, the carrier substrate 12 is cut out of a fused-quartz substrate or a synthetic-quartz substrate. The carrier substrate 12 contains highly pure silicon dioxide. In the present embodiment, while the carrier substrate 12 and the adhesive layer 15 contain an identical material, the carrier substrate 12 and the adhesive layer 15 have different refractive indices from each other. The refractive index of the carrier substrate 12 and the refractive index of the adhesive layer 15 are each a value measured through a spectroscopic ellipsometer ("SE-1000"from Semilab Japan KK). Hence, if the carrier substrate 12 is constituted by a fused-quartz substrate or a synthetic-quartz substrate and the adhesive layer 15 is formed through a process, particularly through a film deposition process, different from the method of manufacturing the carrier substrate 12, the two have different optical properties. As long as the surface properties of the adhesive layer 15 and the surface properties of the carrier substrate 12 are different from each other, the refractive index of the carrier substrate 12 and the refractive index of the adhesive layer 15 may be the same value. In a case where the carrier substrate 12 is constituted by a fused-quartz substrate or a synthetic-quartz substrate while the adhesive layer 15 is a film of silicon dioxide deposited through a CVD method, the carrier substrate 12 and the adhesive layer 15 can have different compositions, in addition to or in replacement of the possible differences in surface roughness and refractive index described above. Thus, the composition of the adhesive layer 15 and the composition of the carrier substrate 12 may be different from each other. In the case where the two have different compositions, the adhesive strength of the release layer 13 may vary between a case where the release layer 13 is directly provided on the carrier substrate 12 and a case where the release layer 13 is provided on the carrier substrate 12 with the adhesive layer 15 in between.

Preferably, the adhesive layer 15 is composed in such a manner as to have a transmissivity of 90% or more with respect to laser light at a predetermined wavelength. In the wiring-substrate group 10, irradiating the release layer 13 with laser light enables the release of the redistribution layer 20 from the carrier substrate 12, which will be described in detail separately below. The redistribution layer 20 is a part of the redistribution-layer group 30. In the releasing step, the laser light is made to incident on the second surface 122 of the carrier substrate 12, exits from the first surface 121, travels through the adhesive layer 15, and reaches the release layer 13. Therefore, the adhesive layer 15 needs to transmit laser light.

As described above, it is preferable that the adhesive layer 15 be composed in such a manner as to have a transmissivity of 90% or more with respect to laser light at a predetermined wavelength. The laser light is allowed to travel through the carrier substrate 12 and the adhesive layer 15 and reach the release layer 13. With the irradiation of the release layer 13 with the laser light, the redistribution layers 20 in the redistribution-layer group 30 can be easily released from the carrier substrate 12 while the surface disturbance of the release layer 13 is suppressed.

In the present embodiment, the laser light to be used for the irradiation of the release layer 13 has a wavelength of 355 nm. That is, the adhesive layer 15 is preferably composed in such a manner as to have a transmissivity of 90% or more with respect to laser light at a wavelength of 355 nm. The laser light to be used for releasing the release layer 13 is not limited, and may be laser light at a wavelength other than 355 nm. The transmissivity of the adhesive layer 15 with respect to the laser light is a value measured through a spectrometer ("a high-speed CCD spectrometer SM245" from Opticanics). The wavelength of the laser light is measured through a photodiode sensor ("FPS-1" from Opto Science, Inc.)

The thickness of the adhesive layer 15 may be, for example, 25 nm or more and 300 nm or less. In such a case, the light transmissivity of the adhesive layer 15 is easy to adjust to a desired state. It is preferable that the adhesive layer 15 be made of a material having favorable light transmissivity and heat resistance. In this respect, it is preferable that the adhesive layer 15 be made of an inorganic material and contain silicon dioxide and/or silicon nitride as described above. Furthermore, ITO (indium tin oxide) can be favorably used as the material for the adhesive layer 15.

The release layer 13 is provided on a surface of the adhesive layer 15 that is located opposite the other surface being in contact with the first surface 121 of the carrier substrate 12. Specifically, the adhesive layer 15 includes a lower surface 151, which is in contact with the first surface 121 of the carrier substrate 12; and an upper surface 152, which is located opposite the lower surface 151. The release layer 13 is provided on the upper surface 152.

The release layer 13 is an element that enables the release of the redistribution layer 20 from the carrier substrate 12, in other words, an element that facilitates the release. The release layer 13 contains resin that absorbs laser light. The release layer 13 is decomposed under laser light. That is, the decomposition of the release layer 13 with energy received from laser light makes the redistribution layer 20 releasable from the carrier substrate 12. It is preferable that the release layer 13 have a decomposition temperature of 300°C or above. In the present embodiment, the release layer 13 contains polyimide. The polyimide contained in the release layer 13 may be a thermosetting polyimide or a photocurable polyimide.

The thickness of the release layer 13 is, for example, 0.3 µm or more and may be 1 µm or more. The thickness of the release layer 13 is, for example, 30 µm or less and may be 50 µm or less.

In the wiring-substrate group 10 illustrated, the intermediate layer 14 that limits the transmission of laser light, or that reflects laser light, is provided on a surface of the release layer 13 that is located opposite the other surface being in contact with the adhesive layer 15. Specifically, the release layer 13 includes a first lower surface 131, which is in contact with the upper surface 152 of the adhesive layer 15; and a first upper surface 132, which is located opposite the first lower surface 131. The intermediate layer 14 is provided on the first upper surface 132.

As described above, in the wiring-substrate group 10, irradiating the release layer 13 with laser light through the carrier substrate 12 realizes the release of the redistribution layer 20 from the carrier substrate 12. In this process, when the laser light reaches the redistribution layer 20, the redistribution layer 20 may deform undesirably. The intermediate layer 14 can block the laser light. The intermediate layer 14 is provided at positions of the redistribution-layer group 30 where the redistribution layers 20 are located. On the other hand, the intermediate layer 14 does not need to be provided at positions of the redistribution-layer group 30 where no redistribution layers 20 are located. That is, the intermediate layer 14 is provided between the release layer 13 and the redistribution layers 20.

In the illustrated example, the intermediate layer 14 is provided partially on the first upper surface 132. Specifically, the intermediate layer 14 is patterned in such a manner as to have a plurality of island portions 14A that are formed at positions of the redistribution-layer group 30 where redistribution layers 20 are to be formed. The plurality of island portions 14A are each located between a single redistribution layer 20 and the release layer 13 in the third direction D3. A gap is provided between adjacent ones of the island portions 14A. The dimension of the gap between the adjacent island portions 14A is, for example, 1.15 mm or more and 3.15 mm or less.

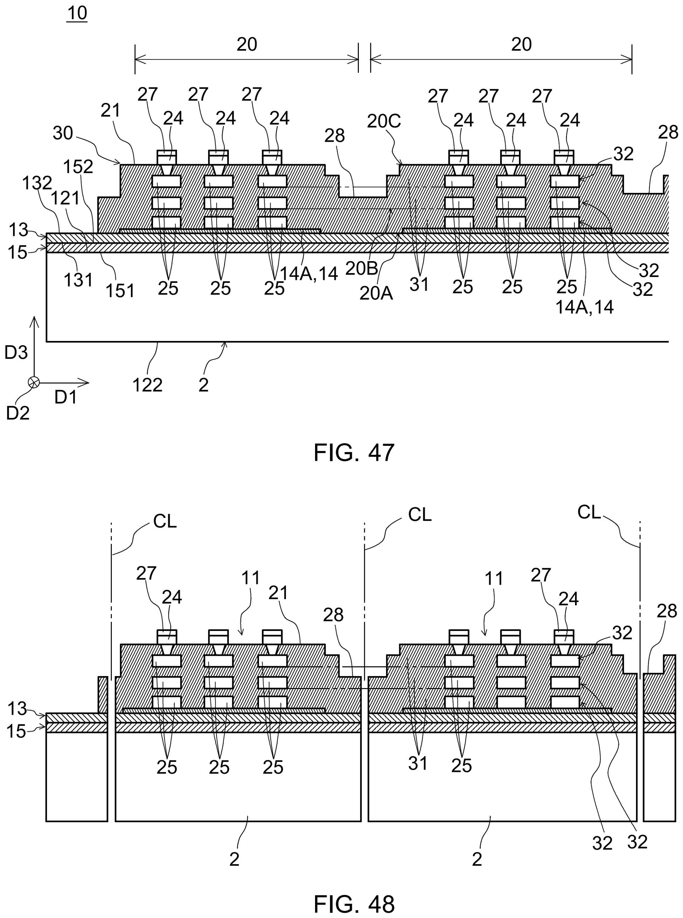

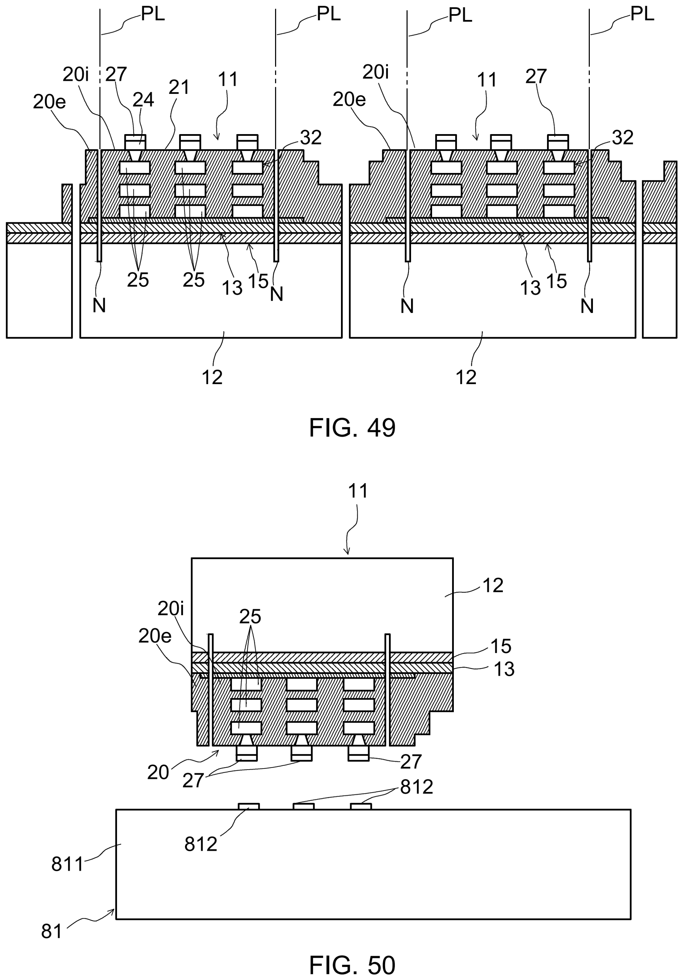

The intermediate layer 14 may contain metal. The intermediate layer 14 may contain at least one kind among titanium, gold, silver, nickel, and copper. For example, the intermediate layer 14 may be formed by pasting a sheet of foil containing at least one kind among titanium, gold, silver, nickel, and copper to the release layer 13 and then patterning the sheet of foil through etching. Preferably, the intermediate layer 14 is composed in such a manner as to have a reflectivity of 90% or more with respect to laser light. That is, the intermediate layer 14 according to the present embodiment is composed in such a manner as to have a reflectivity of 90% or more with respect to laser light preferably at a wavelength of 355 nm. The reflectivity of the intermediate layer 14 with respect to laser light is a value measured through a spectrometer ("a high-speed CCD spectrometer SM245" from Opticanics). The intermediate layer 14 may have a hole. The hole of the intermediate layer 14 allows the gas generated in the release layer 13 to be discharged. For example, the gas generated in the release layer 13 flows through the hole of the intermediate layer 14, reaches the redistribution layer 20, and is discharged to the outside through the redistribution layer 20. It is preferable that the intermediate layer 14 be provided on the inner side relative to cut surfaces or trimmed surfaces. If the intermediate layer 14 is provided on the inner side relative to cut surfaces or trimmed surfaces, the likeliness of detachment of the intermediate layer 14 because of cutting or trimming can be suppressed. The cut surfaces refer to surfaces that are made when the redistribution layer 20 is cut out in an individuation step, which will be described separately below with reference to Fig. 48. The trimmed surfaces refer to surfaces that are made when the redistribution layer 20 is trimmed in a trimming step, which will be described separately below with reference to Fig. 49. In the present embodiment, as illustrated in Fig. 48 to be referred to below, the ends of the intermediate layer 14 are located on the inner side relative to the cut surfaces that are made by the cutting performed in the individuation step. In other words, the intermediate layer 14 is provided at such a position as not to be cut in the individuation step. As illustrated in Fig. 49 to be referred to below, the ends of the intermediate layer 14 are located on the outer side relative to the trimmed surfaces that are made in the trimming step. In other words, the intermediate layer 14 is provided at such a position as to be cut in the trimming step. The intermediate layer 14 may be located on the inner side relative to both the cut surfaces that are made in the cutting performed in the individuation step and the trimmed surfaces that are made in the trimming step.

The thickness of the intermediate layer 14 is, for example, 0.3 µm or more and may be 1 µm or more. The thickness of the intermediate layer 14 is, for example, 30 µm or less and may be 50 µm or less.

### (Redistribution Layer and Redistribution-Layer Group Intermediate interposer layer)

The redistribution layer 20 and the redistribution-layer group 30 will now be described. The redistribution layer 20 is provided on the carrier substrate 12 with the adhesive layer 15 and the release layer 13 in between. In the present embodiment, the redistribution-layer group 30 that includes a plurality of redistribution layers 20 is formed on the release layer 13, whereby the plurality of redistribution layers 20 are collectively and simultaneously formed on the carrier substrate 12. As described above, the redistribution-layer group 30 includes a plurality of redistribution layers 20 that are connected to one another as illustrated in Figs. 39 and 40.

The redistribution-layer group 30, i.e. the plurality of redistribution layers 20, is releasably provided on the first surface 132, which is the surface of the release layer 13 that is located opposite the other surface being in contact with the adhesive layer 15. In the present embodiment, as described above, the intermediate layer 14 is provided partially on the first upper surface 132. Specifically, the redistribution-layer group 30 is provided such that portions constituting the redistribution layers 20 overlap the intermediate layer 14 and such that portions not constituting the redistribution layers 20 each face the release layer 13 without the intermediate layer 14 in between.

The plurality of redistribution layers 20 included in the redistribution-layer group 30 each include an insulating layer 21 and a plurality of wires 25, which are covered by the insulating layer 21. The redistribution-layer group 30 includes a front-end insulating layer 31 and a front-end wiring layer 32. The front-end insulating layer 31 is a layer formed as a collection of portions that constitute the insulating layers 21 of the individual redistribution layers 20. The front-end wiring layer 32 is a layer formed as a collection of some or all of the wires 25 that are included in the individual redistribution layers 20. The front-end insulating layer 31 contains resin. The insulating layers 21 of the individual redistribution layers 20 contain the same resin as the front-end insulating layer 31 does. The front-end insulating layer 31 is a portion that entirely covers the plurality of wires 25 included in the front-end wiring layer 32. The front-end insulating layer 31 functions as an insulating layer having an insulation characteristic. Accordingly, the insulating layers 21 included in the redistribution layers 20 also function as insulating layers. The insulation characteristic refers to having a volume resistivity of 10¹⁰ Ω/m or more.

The redistribution-layer group 30 includes a third upper surface 202 and a third lower surface 201. The third lower surface 201 is located opposite the third upper surface 202. The redistribution-layer group 30 may include a plurality of wiring layers that are stacked. In the example illustrated in Fig. 39, the redistribution-layer group 30 includes a first wiring layer 20A, a second wiring layer 20B, and a third wiring layer 20C. The plurality of wiring layers may each include a front-end insulating layer 31 and a front-end wiring layer 32. The front-end insulating layer 31 of the first wiring layer 20A may constitute the third lower surface 201 of the redistribution-layer group 30. The front-end insulating layer 31 of the third wiring layer 20C may constitute the third upper surface 202 of the redistribution-layer group 30. While the wires 25 included in the front-end wiring layer 32 of the first wiring layer 20A overlap the intermediate layer 14, a portion of the front-end insulating layer 31 may be located between each of the wires 25 and the intermediate layer 14.

The redistribution-layer group 30 may include a through via. The through via is an electrically conductive portion extending in the third direction D3 in a single wiring layer. The through via is capable of electrically connecting between the front-end wiring layers 32 included in two wiring layers that are adjacent to each other in the third direction D3.

As illustrated in Fig. 39, the redistribution-layer group 30 may include a pad 24. The pad 24 is provided in such a manner as to project from the third upper surface 202 of the redistribution-layer group 30. In the illustrated example, a plurality of pads 24 are provided on the third wiring layer 20C. The pads 24 are provided in such a manner as to be exposed from the front-end insulating layer 31 of the third wiring layer 20C and project from the third upper surface 202 of the redistribution-layer group 30 that is constituted by the third wiring layer 20C. The pads 24 are electrically connected to some of the wires 25 included in the front-end wiring layer 32 covered by the front-end insulating layer 31 of the third wiring layer 20C.

The pads 24 may each have a bump 27. The bump 27 contains an electrically conductive material. For example, the bump 27 contains solder. The bump 27 may be connected to a terminal of a BGA (ball grid array) or to a terminal of a semiconductor device.

The redistribution-layer group 30 has a groove 28, which defines a region in which each redistribution layer 20 is located. The groove 28 is recessed from the third upper surface 202 of the redistribution-layer group 30 toward the third lower surface 201. In the third direction D3, the bottom surface of the groove 28 is located between the third upper surface 202 and the third lower surface 201. For example, the bottom surface of the groove 28 is located in a halfway part between the third upper surface 202 and the third lower surface 201. The redistribution layers 20 can be cut out by cutting the redistribution-layer group 30 and the carrier substrate 12 of the wiring-substrate group 10 along the groove 28.

As illustrated in Fig. 40, the groove 28 has, for example, a lattice pattern in plan view. In this example, the redistribution layers 20 are located on the inner side of a plurality of openings in the lattice pattern of the groove 28. That is, the redistribution layers 20 are located in regions enclosed in plan view by the groove 28 having a lattice pattern. The groove 28 may be made by, for example, etching a material layer constituting the front-end insulating layer 31 of the third wiring layer 20C, or by removing a portion of the material layer with a cutting tool. Alternatively, the groove 28 may be omitted. In the present embodiment, the wiring-substrate group 10 is cut along the groove 28, whereby the redistribution layers 20 are cut out together with portions of the carrier substrate 12, that is, individuation is performed. This cutting may be performed with a cutting edge or through the irradiation with laser light.

The thickness of the redistribution-layer group 30 is, for example, 30 µm or more and may be 35 µm or more. The thickness of the redistribution-layer group 30 is, for example, 50 µm or less and may be 45 µm or less. The thickness of the redistribution-layer group 30 is the distance in the third direction D3 from the third upper surface 202 to the third lower surface 201. The thickness of each of the wiring layers included in the redistribution-layer group 30 is, for example, 4.0 µm or more and may be 6.0 µm or more. The thickness of each of the wiring layers included in the redistribution-layer group 30 is, for example, 12.0 µm or less and may be 10.0 µm or less. The thickness of the redistribution layer 20 is the same as the thickness of the redistribution-layer group 30.

The thickness of the electrically conductive layer, such as the wire 25 or the pad 24, included in the redistribution layer 20 is, for example, 0.1 µm or more and may be 0.5 µm or more or 1.0 µm or more. The thickness of the electrically conductive layer such as the wire 25 or the pad 24 is, for example, 10.0 µm or less and may be 5.0 µm or less.

The width of the wire 25 is, for example, 0.5 µm or more and may be 1.0 µm or more. The width of the wire 25 is, for example, 5.0 µm or less and may be 3.0 µm or less or 2.0 µm or less. The interval between two wires 25 that are adjacent to each other in plan view is, for example, 0.5 µm or more and may be 1.0 µm or more. The interval between two wires 25 that are adjacent to each other in plan view is, for example, 5.0 µm or less and may be 3.0 µm or less or 2.0 µm or less. The front-end wiring layer 32 may include not only wires 25 that satisfy the above numerical ranges but also wires 25 that do not satisfy the above numerical ranges.

The resin contained in the front-end insulating layer 31 (the material of the front-end insulating layer 31), i.e. the resin contained in the insulating layer 21 included in the redistribution layer 20 (the material of the insulating layer 21), may contain resin such as polyimide or the like. The resin of the front-end insulating layer 31 and the resin of the insulating layer 21 may be at least one of polyimide, epoxy resin, acrylic, bismaleimide, polybenzoxazole, and benzocyclobutene.

The wire 25 (front-end wiring layer 32), the pad 24, and the through via each contain an electrically conductive material. For example, the wire 25 (front-end wiring layer 32) and the pad 24 may each contain metal such as copper, gold, silver, platinum, rhodium, tin, aluminum, nickel, or chromium; or an alloy of any of the foregoing.

### (Method of Manufacturing Redistribution Layer)

A method of manufacturing the redistribution layer 20 will now be described. The following description relates to a process of manufacturing a wiring-substrate group 10 and then manufacturing a redistribution layer 20 from the wiring-substrate group 10.

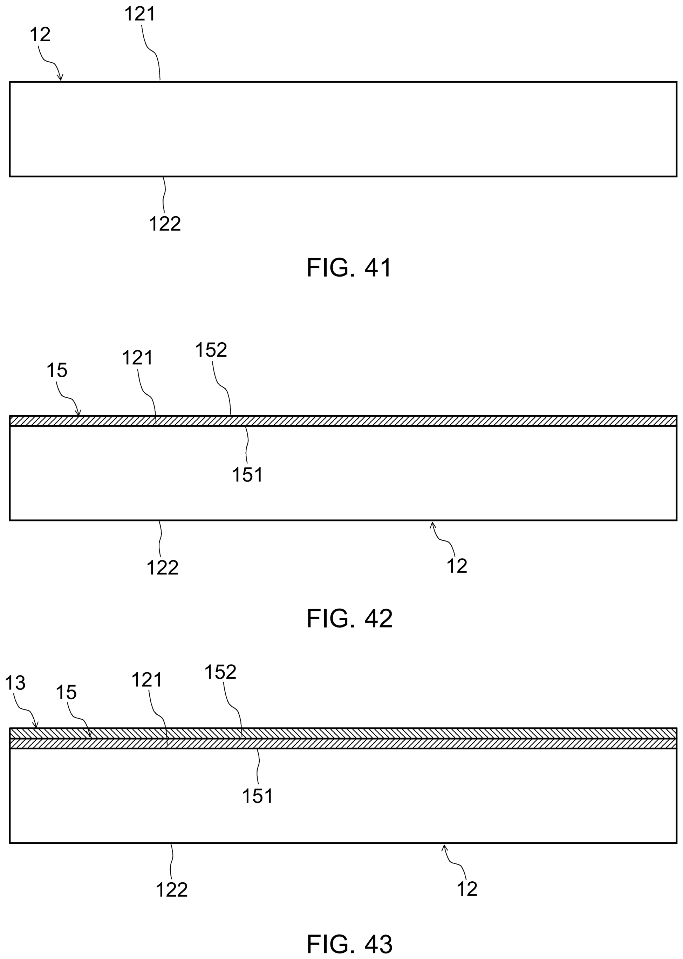

As illustrated in Fig. 41, a carrier substrate 12 is prepared. In the present embodiment, a quartz substrate is prepared as a carrier substrate 12.

Subsequently, as illustrated in Fig. 42, an adhesive layer 15 is provided on the first surface 121 of the carrier substrate 12 (an adhesive-layer-forming step). In the present embodiment, the adhesive layer 15 is formed by, for example, depositing a film of silicon dioxide on the first surface 121 through plasma CVD. The adhesive layer 15 is formed in such a manner as, for example, to have a transmissivity of 90% or more with respect to laser light at a wavelength of 355 nm and also to have an arithmetic mean height of 0.01 µm or more and 0.1 µm or less. The thickness of the adhesive layer 15 may be within a range of 25 nm or more and 300 nm or less.

Subsequently, as illustrated in Fig. 43, a release layer 13 is provided on the upper surface 152 of the adhesive layer 15 (a release-layer-forming step). As described above, the release layer 13 is an element that enables the release of the redistribution layer 20 included in the redistribution-layer group 30 from the carrier substrate 12. In other words, the release layer 13 is an element that facilitates the release. In the present embodiment, the release layer 13 contains polyimide. In such a case, polyimide that is yet to be hardened is applied to the upper surface 152 of the adhesive layer 15, and is then hardened. If the polyimide is thermosetting, the polyimide is hardened by receiving heat. If the polyimide is photocurable, the polyimide is hardened by receiving light.

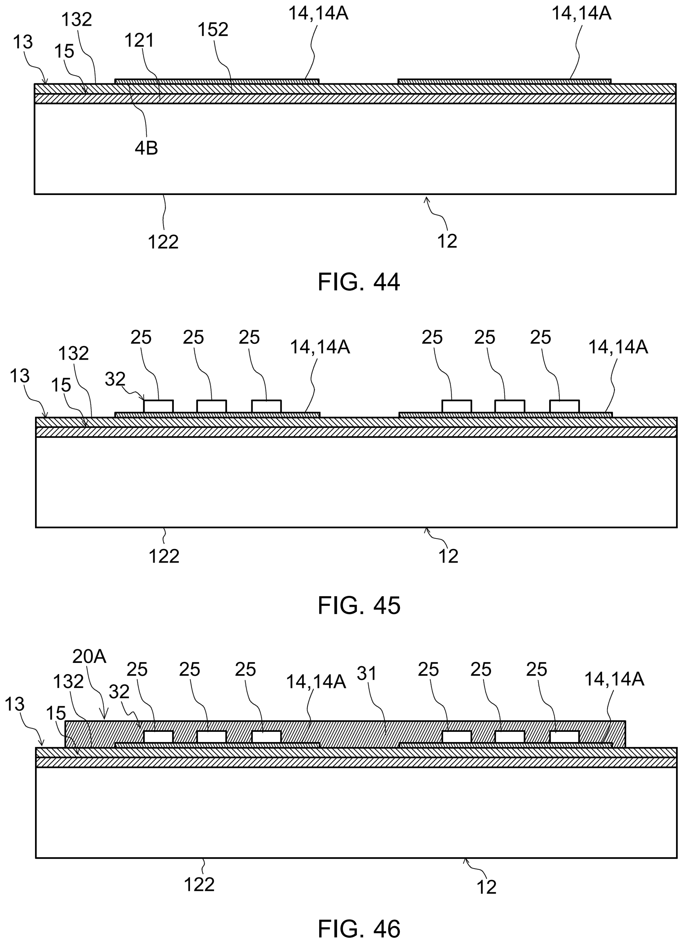

Subsequently, as illustrated in Fig. 44, an intermediate layer 14, which absorbs laser light, is provided partially on the first upper surface 132 of the release layer 13 (an intermediate-layer-forming step). The intermediate layer 14 is provided in such a manner as to be located between the release layer 13 and the redistribution layer 20 to be formed thereafter. As described above, the intermediate layer 14 may contain at least one kind among titanium, gold, silver, nickel, and copper. In such a case, the intermediate layer 14 may be formed by pasting a sheet of foil containing at least one kind among titanium, gold, silver, nickel, and copper to the release layer 13 and then patterning the sheet of foil.

Subsequently, one or a plurality of redistribution layers 20 are formed on the release layer 13 and the intermediate layer 14. In other words, in the present embodiment, a redistribution-layers-forming step is performed in which a redistribution-layer group 30 including a plurality of redistribution layers 20 is formed. In this step, as illustrated in Fig. 45, a front-end wiring layer 32 including a plurality of wires 25 to be included in the redistribution layers 20 is first formed. All or most of the wires 25 included in the front-end wiring layer 32 are formed on the intermediate layer 14. In this step, the wires 25 may be formed on the intermediate layer 14 directly or with an insulating resin in between.

Subsequently, as illustrated in Fig. 46, a step of forming a front-end insulating layer 31 that covers the front-end wiring layer 32 formed in Fig. 45 is performed. Thus, a first wiring layer 20A is obtained. Subsequently, as with the case of the step of forming the first wiring layer 20A, a front-end wiring layer 32 and a front-end insulating layer 31 are formed alternately, whereby a second wiring layer 20B and a third wiring layer 20C are obtained. Thus, as illustrated in Fig. 47, a redistribution-layer group 30 including the first wiring layer 20A, the second wiring layer 20B, and the third wiring layer 20C is obtained. That is, a wiring-substrate group 10 is manufactured.

In the present embodiment, a groove 28 that defines the regions where the individual redistribution layers 20 are located is made in the redistribution-layer group 30. The groove 28 may be made by, for example, etching a material layer constituting the front-end insulating layer 31 of the third wiring layer 20C, or by removing a portion of the material layer with a cutting tool.

Subsequently, as illustrated in Fig. 48, an individuation step is performed in which the redistribution layers 20 are each cut out together with a portion of the carrier substrate 12 from the carrier substrate 12 and the redistribution-layer group 30, i.e. the wiring-substrate group 10. In the present embodiment, as illustrated in Fig. 48, the wiring-substrate group 10 is cut along lines CL, which extend along the groove 28 and are parallel to the third direction D3. Thus, the redistribution layers 20 are cut out together with portions of the carrier substrate 12, that is, individuation is performed. This cutting may be performed with a cutting edge or through the irradiation with laser light. Through the above individuation step, a plurality of wiring substrates 11 each including a portion of the carrier substrate 12 and a redistribution layer 20 are obtained. To be exact, the portion of the carrier substrate 12 that has been cut out in the individuation step is a different body from the entire body of the carrier substrate 12, but is hereinafter denoted by reference sign 12 for the convenience of description. In the individuation step according to the present embodiment, the intermediate layer 14 is not cut.

Subsequently, as illustrated in Fig. 49, a trimming step is performed. The trimming step involves each redistribution layer 20 and the corresponding portion of the carrier substrate 12 that have been cut out in the individuation step, i.e. the wiring substrate 11, and is a step of separating an outer peripheral portion 20e of the redistribution layer 20 from an inner portion 20i of the redistribution layer 20. In the trimming step, an incision N is made to separate the outer peripheral portion 20e of the redistribution layer 20 from the inner portion 20i. The incision N extends through the redistribution layer 20 and reach a halfway position of the carrier substrate 12 in a direction in which the redistribution layer 20 and the portion of the carrier substrate 12 overlap each other. The incision N is continuous to have a rectangular shape in plan view. The inner portion 20i of the redistribution layer 20 has a rectangular shape in plan view. Such a trimming step may be omitted.

Subsequently, as illustrated in Fig. 50, the wiring substrate 11 obtained through the trimming step is taken out. The wiring substrate 11, which has been oriented as illustrated in Fig. 49, is turned upside down to face a first member 81. The first member 81 includes a substrate 811 and a plurality of terminals 812, which are provided on a surface of the substrate 811. The wiring substrate 11 is oriented such that the bumps 27 on the redistribution layer 20 thereof face the respective terminals 812 of the first member 81.

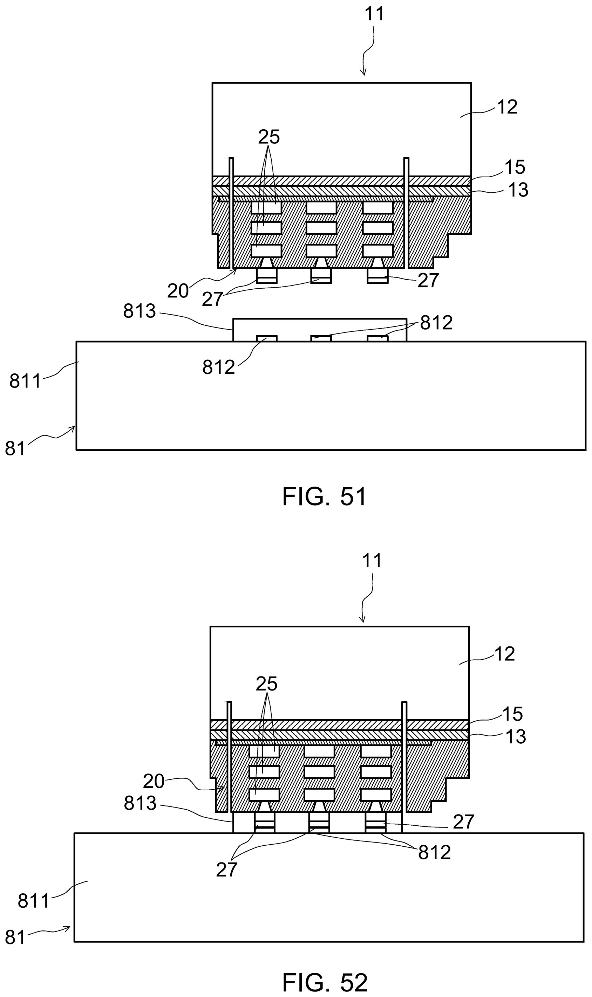

Subsequently, as illustrated in Fig. 51, a heat-sensitive adhesive layer 813 is provided over the plurality of terminals 812 of the first member 81. The adhesive layer 813 may be either of NCP (nonconductive paste) and NCF (nonconductive film), which are electrically nonconductive adhesive materials; or underfill. NCP, NCF, and underfill each contain thermosetting resin. The adhesive layer 813 may be any other thermobonding resin. The adhesive layer 813 may be provided on the redistribution layer 20 in such a manner as to cover the bumps 27.

Subsequently, as illustrated in Fig. 52, the wiring substrate 11 is positioned with respect to the first member 81 such that the bumps 27 on the redistribution layer 20 and the terminals 812 of the first member 81 come into contact with each other. Subsequently, the adhesive layer 813 is heated. Thus, the wiring substrate 11 is integrated with the first member 81 while the bumps 27 on the redistribution layer 20 and the terminals 812 of the first member 81 are electrically connected to each other.

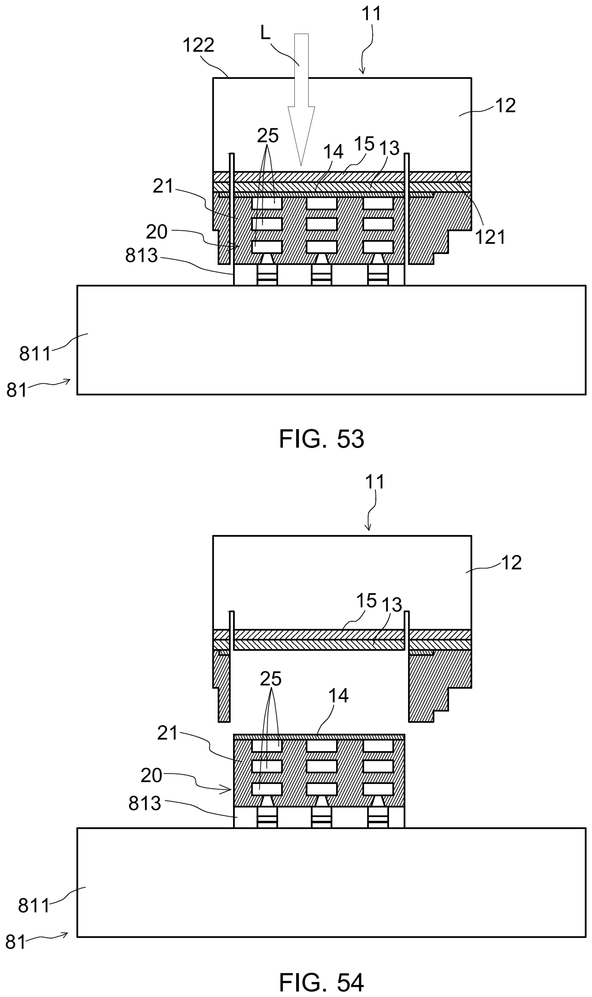

Subsequently, as illustrated in Fig. 53, a release-treatment step is performed. In the release-treatment step, the release layer 13 is irradiated with laser light L through the adhesive layer 15. The laser light L is received at the second surface 122 of the carrier substrate 12 (to be exact, the portion of the carrier substrate 12), is transmitted through the first surface 121, and reaches the release layer 13. Through the release-treatment step, the redistribution layer 20 becomes releasable from the carrier substrate 12 and the adhesive layer 15. To be exact, the inner portion 20i of the redistribution layer 20 that has been separated from the outer peripheral portion 20e in the trimming step becomes releasable from the portion of the carrier substrate 12 and the adhesive layer 15 overlying the portion. In the present example, the laser light L received by the release layer 13 generates heat, which decomposes the release layer 13. Thus, the release layer 13 allows the release of the redistribution layer 20.

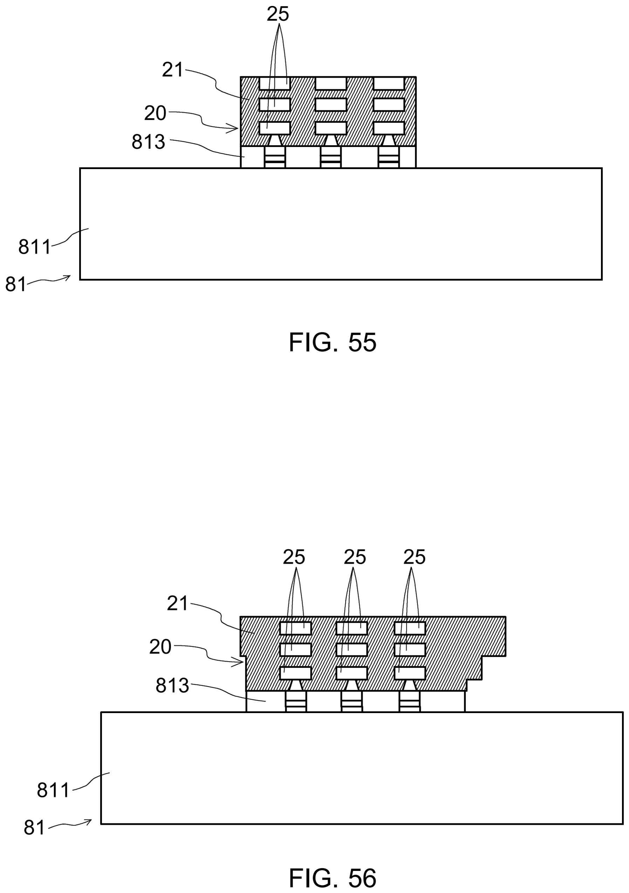

As illustrated in Fig. 54, the portion of the carrier substrate 12 is pulled apart from the redistribution layer 20. Subsequently, as illustrated in Fig. 55, the intermediate layer 14 is removed. The removal of the intermediate layer 14 may be performed through, for example, etching. Part of the release layer 13 may remain adhered to the intermediate layer 14. In that case, such release layer 13 is removed before the intermediate layer 14 is removed. The removal of the release layer 13 may be performed through, for example, ashing. With the removal of the intermediate layer 14, a redistribution layer 20 separated from the carrier substrate 12 is obtained. To be exact, a redistribution layer 20 integrated with the first member 81 is obtained.

In the embodiment described above, the release layer 13 is provided on the first surface 121 of the carrier substrate 12 with the adhesive layer 15 in between, and the plurality of redistribution layers 20 (redistribution-layer group 30) are provided on the release layer 13. With the use of the adhesive layer 15, the adhesive strength of the release layer 13 with respect to the carrier substrate 12 can be increased. Thus, the detachment of the release layer 13 can be suppressed. Specifically, what can be suppressed is the detachment of the release layer 13 from the carrier substrate 12 during a period after the release layer 13 is irradiated with the laser light L through the adhesive layer 15 and before the redistribution layers 20 are released from the carrier substrate 12 and the adhesive layer 15. Thus, each of the redistribution layers 20 can be appropriately released after the release-treatment step and can be smoothly and appropriately transferred to, for example, the first member 81.

In the present embodiment, the individuation step is performed in which the redistribution layer 20 is cut out together with a portion of the carrier substrate 12 from the wiring-substrate group 10. In a typical manufacturing process, the adhesive layer 15 described in the present embodiment is not provided, and the release layer is directly provided on the carrier substrate. In such a process, however, detachment of the release layer tends to occur from the cut surface after the individuation step, which accompanies cutting. In contrast, according to the present embodiment, since the adhesive layer 15 is provided, the risk of detachment of the release layer 13 because of individuation can be reduced.

In the present embodiment, the trimming step is performed in which on the redistribution layer 20 and the portion of the carrier substrate 12 that are cut out in the individuation step, the outer peripheral portion 20e of the redistribution layer 20 is separated from the inner portion 20i thereof. In the typical manufacturing process in which the adhesive layer 15 is not provided and the release layer is directly provided on the carrier substrate, detachment of the release layer also tends to occur from the cut surface that is made in such trimming. In contrast, according to the present embodiment, since the adhesive layer 15 is provided, the risk brought on the release layer 13 by the trimming can also be reduced.

In the present embodiment, the adhesive layer 15 is formed through a CVD method. Thus, an efficient formation of the adhesive layer 15 can be achieved. Specifically, the adhesive layer 15 according to the present embodiment is intended for close adhesion of the release layer 13 and is not strongly desired to have high density or smoothness. Hence, the present embodiment employs a CVD method, which may not necessarily be favorable compared with deposition or sputtering in terms of ensuring high film density but is easier to perform. Thus, an efficient formation of the adhesive layer 15 can be achieved.

In the present embodiment, the carrier substrate 12 and the adhesive layer 15 contain an identical material. Thus, the adhesive layer 15 can be firmly bonded to the carrier substrate 12. In particular, the carrier substrate 12 and the adhesive layer 15 contain silicon dioxide. Such a case is advantageous in terms of cost and in terms of ensuring a desired transmissivity with respect to laser light.

Preferably, the adhesive layer 15 is composed in such a manner as to have a transmissivity of 90% or more with respect to laser light at a predetermined wavelength. If the adhesive layer 15 can assuredly have a transmissivity of 90% or more with respect to laser light, an even interface of separation is obtained at the decomposition of the release layer 13 with the laser light. Therefore, the release of the redistribution layer 20 can be performed smoothly while deformation is suppressed as desired.

The arithmetic mean height of the adhesive layer 15 is preferably 0.01 µm or more and 0.1 µm or less. Within such a range, the adhesive layer 15 and the release layer 13 can be firmly bonded to each other.

The one embodiment described above can be changed in various ways. For example, in the above embodiment, the wiring-substrate group 10 includes a plurality of redistribution layers 20. Furthermore, the wiring-substrate group 10 is individuated to manufacture the plurality of redistribution layers 20. Alternatively, the wiring-substrate group 10 may include a single redistribution layer 20 provided on the carrier substrate 12 with the adhesive layer 15 and the release layer 13 in between. In that case, although the individuation step is not required and the trimming step is not necessarily required, the occurrence of detachment of the release layer 13 before the redistribution layer 20 is released can be suppressed.

While some variations of the above embodiment have been described, some of the variations can be combined according to need to be applied to the above embodiment, of course.

### (First Variation)

Fig. 56 illustrates a variation of the above embodiment. The redistribution layer 20 illustrated in Fig. 56 has been transferred to the first member 81 with no performance of the trimming step after the individuation step described with reference to Fig. 48.

### (Second Variation)

While the above embodiment has described an example in which the intermediate layer 14 has a light-blocking characteristic, the intermediate layer 14 may not necessarily need to have a light-blocking characteristic. For example, the intermediate layer 14 may contain an inorganic material having an insulation characteristic. Examples of the inorganic material include inorganic oxide, inorganic nitride, and the like. Examples of inorganic oxide include silicon oxide such as SiO₂. Examples of inorganic nitride include silicon nitride such as SiN. The inorganic material may be SiOC, SiC, SiOF, SiON, SiCN, or the like.

The coefficient of thermal expansion of the inorganic material for the intermediate layer 14 is smaller than the coefficient of thermal expansion of the organic material for the insulating layer 21. The coefficient of thermal expansion of the inorganic material is, for example, 10.0 ppm/°C or less and may be 8.0 ppm/°C or less or 5.0 ppm/°C or less.

The step of forming the redistribution layer 20 may include a step to be performed at high temperature, such as a step of heating the insulating layer 21. The coefficient of thermal expansion of the organic material for the insulating layer 21 is greater than the coefficient of thermal expansion of the other elements of the wiring-substrate group 10. For example, the coefficient of thermal expansion of the organic material for the insulating layer 21 is greater than the coefficients of thermal expansion of substrates such as the carrier substrate 12. For example, the coefficient of thermal expansion of the organic material for the insulating layer 21 is greater than the coefficient of thermal expansion of the electrically conductive layer 22. When the temperature of the elements included in the redistribution layer 20 decreases after the heating step, a stress may occur because of the difference in the coefficient of thermal expansion between the insulating layer 21 and the other elements. For example, the substrates, the electrically conductive layer 22, and other elements may be subjected to a stress.

According to the present variation, since the intermediate layer 14 contains an inorganic material, the influence of the stress attributed to the insulating layer 21 and brought upon the carrier substrate 12 and others can be suppressed. Therefore, for example, warping of the redistribution layer 20, the wiring-substrate group 10, or the wiring substrate 11 can be suppressed.

### (Third Variation)

The features of the first embodiment described above may be combined with any of the features of the second embodiment described above. For example, the wiring-substrate group 10 according to the first embodiment described above may include the adhesive layer 15 located between the carrier substrate 12 and the release layer 13. The features of the second embodiment described above may be combined with any of the features of the first embodiment described above. For example, the intermediate layer 14 of the wiring-substrate group 10 according to the second embodiment described above may have an opening.

### Reference Signs List

10 wiring-substrate group
11 wiring substrate
12 carrier substrate
13 release layer
131 first lower surface
132 first upper surface
14 intermediate layer
141 second lower surface
142 second upper surface
143 first opening
144 second opening
14A island portion
15 adhesive layer
151 lower surface
152 upper surface
20 redistribution layer
201 third lower surface
202 third upper surface
203 third lateral surface
20A first wiring layer
20B second wiring layer
20C third wiring layer
20e outer peripheral portion
20i inner portion
21 insulating layer
21A first region
21B second region
21B1 first second region
22 electrically conductive layer
221 seed layer
222 plating layer
24 pad
25 wire
26 through via
27 bump
28 groove
31 front-end insulating layer
32 front-end wiring layer
71 first resist layer
81 first member
82 second member

## Claims

1. A wiring-substrate group comprising:
a carrier substrate;
a release layer including a first lower surface and a first upper surface, the first lower surface facing the carrier substrate, the first upper surface being located opposite the first lower surface, the release layer containing resin;
an intermediate layer including a second lower surface and a second upper surface, the second lower surface facing the first upper surface, the second upper surface being located opposite the second lower surface, the intermediate layer containing metal; and
a plurality of redistribution layers each including a third lower surface and a third upper surface, the third lower surface facing the second upper surface at least partially, the third upper surface being located opposite the third lower surface, the plurality of redistribution layers being aligned in a first direction,
wherein the redistribution layers each include a first wiring layer constituting the third lower surface,
wherein the first wiring layer includes electrically conductive layers and an insulating layer, the electrically conductive layers each containing a metal that is different from the metal of the intermediate layer, the insulating layer containing resin, and
wherein the intermediate layer includes an opening at which the first upper surface is exposed.

2. The wiring-substrate group according to claim 1, wherein the opening includes a first opening located in plan view between the electrically conductive layers of each two of the redistribution layers, the two redistribution layers being adjacent to each other in the first direction.

3. The wiring-substrate group according to claim 2, wherein the first opening has a dimension in the first direction of 100 µm or more and 500 µm or less.

4. The wiring-substrate group according to claim 2, wherein a ratio of a dimension of the first opening in the first direction with respect to an arrangement pitch of the plurality of redistribution layers in the first direction is 0.0010 or more and 0.10 or less.

5. The wiring-substrate group according to claim 1,
wherein the insulating layer includes a second region and a first region, the second region being located in plan view in a region where the electrically conductive layers are distributed, the first region enclosing the second region in plan view, and
wherein the opening includes a plurality of second openings overlapping the second region in plan view.

6. The wiring-substrate group according to claim 5, wherein the second openings each have a dimension of 50 µm or less in plan view.

7. The wiring-substrate group according to claim 5, wherein a ratio of an area of the plurality of second openings with respect to an area of the second region is 0.0010 or more and 0.10 or less.

8. The wiring-substrate group according to claim 5, wherein the electrically conductive layers included in the first wiring layer include a plurality of pads that are each located at the third lower surface and between corresponding two of the second openings, the two second openings being adjacent to each other in plan view.

9. The wiring-substrate group according to any of claims 1 to 8,
wherein the intermediate layer contains titanium, nickel, molybdenum, tungsten, tantalum, or chromium or an alloy containing any of such metals, and
wherein the electrically conductive layers each contain copper or a copper alloy.

10. The wiring-substrate group according to any of claims 1 to 8, wherein a portion of the insulating layer included in the first wiring layer is located at the opening and is in contact with the first upper surface of the release layer.

11. The wiring-substrate group according to any of claims 1 to 8, further comprising semiconductor devices located at the third upper surfaces of the redistribution layers.

12. A method of manufacturing a wiring-substrate group, comprising:
a step of preparing a multilayer body including a carrier substrate and a release layer, the release layer including a first lower surface and a first upper surface, the first lower surface facing the carrier substrate, the first upper surface being located opposite the first lower surface, the release layer containing resin;
an intermediate-layer step of forming an intermediate layer including a second lower surface and a second upper surface, the second lower surface facing the first upper surface, the second upper surface being located opposite the second lower surface, the intermediate layer containing metal; and
a redistribution-layer-forming step of forming a plurality of redistribution layers each including a third lower surface and a third upper surface, the third lower surface facing the second upper surface at least partially, the third upper surface being located opposite the third lower surface, the plurality of redistribution layers being aligned in a first direction,
wherein the redistribution layers each include a first wiring layer constituting the third lower surface,
wherein the first wiring layer includes electrically conductive layers and an insulating layer, the electrically conductive layers each containing a metal that is different from the metal of the intermediate layer, the insulating layer containing resin, and
wherein the intermediate layer has an opening at which the first upper surface is exposed.

13. The method of manufacturing a wiring-substrate group according to claim 12, wherein the redistribution-layer-forming step includes a step of applying a resin solution containing resin and a solvent to the intermediate layer, and a step of heating the resin solution applied to the intermediate layer.

14. A wiring substrate comprising:
a carrier substrate;
a release layer including a first lower surface and a first upper surface, the first lower surface facing the carrier substrate, the first upper surface being located opposite the first lower surface, the release layer containing resin;
an intermediate layer including a second lower surface and a second upper surface, the second lower surface facing the first upper surface, the second upper surface being located opposite the second lower surface, the intermediate layer containing metal; and
a redistribution layer including a third lower surface and a third upper surface, the third lower surface facing the second upper surface at least partially, the third upper surface being located opposite the third lower surface,
wherein the redistribution layer includes a first wiring layer constituting the third lower surface,
wherein the first wiring layer includes electrically conductive layers and an insulating layer, the electrically conductive layers each containing a metal that is different from the metal of the intermediate layer, the insulating layer containing resin, and
wherein the insulating layer includes a second region and a first region, the second region being located in plan view in a region where the electrically conductive layers are distributed, the first region enclosing the second region in plan view, and
wherein the intermediate layer has a plurality of second openings that overlap the second region in plan view and at which the first upper surface is exposed.

15. A method of manufacturing a wiring substrate, comprising:
a step of preparing the wiring-substrate group according to any one of claims 1 to 8; and
a step of cutting the wiring-substrate group along a boundary between each two of the redistribution layers, the two redistribution layers being adjacent to each other in plan view.
